# EUROPEAN PATENT APPLICATION

(11) **EP 4 733 884 A1**
(43) Date of publication of application: **29.04.2026**
(21) Application number: 24845986.9
(22) Date of filing: 22.07.2024
(51) Int. Cl.: G06F 1/16, H05K 1/14

(54) **FOLDABLE ELECTRONIC DEVICE**

(30) Priority: 21.07.2023 KR 20230095288; 02.11.2023 KR 20230150169
(71) Applicant: Samsung Electronics Co., Ltd., Suwon-si, Gyeonggi-do 16677 (KR)
(72) Inventor: OH, Chanhee, Suwon-si, Gyeonggi-do 16677 (KR); KIM, Yonghwa, Suwon-si, Gyeonggi-do 16677 (KR); KIM, Eungwon, Suwon-si, Gyeonggi-do 16677 (KR)
(74) Representative: Gulde & Partner
(86) International application number: PCT/KR2024/010564
(87) International publication number: WO 2025/023684

(57) **Abstract**

According to an exemplary embodiment of the present disclosure, the provided foldable electronic device comprises: a first housing; a second housing; a hinge unit; a first display; a second display; a display driving circuit; a printed circuit board; and a battery. The hinge unit connects the first housing and the second housing. The first display is arranged in the first housing and the second housing and is arranged across the hinge unit. The second display is positioned on the opposite side of the first display and is arranged in the first housing. The display driving circuit is arranged on the rear surface of the second display. The printed circuit board is accommodated in the first housing. The battery is accommodated in the first housing. The first housing includes a first side surface portion, a second side surface portion and a third side surface portion. The first side surface portion and the second side surface portion extend in a first direction that is perpendicular to the folding axis of the foldable electronic device, and can be spaced apart from each other in a second direction of the folding axis. The third side surface portion is spaced apart from the folding axis in the first direction and extends in the second direction. When viewed from above the second display, the printed circuit board is positioned between the battery and the third side surface portion of the first housing. The battery includes a first portion including battery cells, and a second portion including a battery protection circuit. When viewed from above the second display, the second portion of the battery is positioned between the first portion of the battery and the first side surface portion of the first housing. The second portion of the battery is positioned farther than the first portion of the battery away from the second display. When viewed from above the second display, the display driving circuit extends in the first direction and overlaps the second portion of the battery.

## Description

### [Technical Field]

The disclosure relates to a foldable electronic device.

### [Background Art]

A foldable electronic device may include not only a foldable display but also a display (e.g., sub-display) capable of using in a folded state thereof.

The foregoing information may be provided as the related art for the purpose of facilitating an understanding of the disclosure. No assertion or determination is made as to whether any of the foregoing description may be applied as the prior art related to the disclosure.

### [Disclosure of Invention]

### [Technical Problem]

With the trend toward device thinning, internal structures of foldable electronic devices have become increasingly complex, thereby restricting the expansion of sub-displays.

Various embodiments of the disclosure provide a foldable electronic device capable of expanding a sub-display without hindering the thinning of the foldable electronic device. Various embodiments of the disclosure are provided to solve or at least mitigate the above-mentioned problems.

The technical problems to be achieved in the disclosure are not limited to those described above, and other technical problems not expressly described herein will be understood by those skilled in the art from the following description.

### [Solution to Problem]

According to an exemplary embodiment of the disclosure, a foldable electronic device includes a first housing, a second housing, a hinge portion, a first display (e.g., a foldable display or a flexible display as a main display), a second display (e.g., a sub-display), a display driver integrated circuit, a printed circuit board, and a battery. The hinge portion connects the first housing and the second housing. The first display is disposed in the first housing and the second housing, and is disposed across the hinge portion. The second display is located on an opposite side of the first display and is disposed in the first housing. The display driver integrated circuit is disposed on a rear surface of the second display. The printed circuit board is accommodated in the first housing. The battery is accommodated in the first housing. The first housing includes a first lateral portion, a second lateral portion, and a third lateral portion. The first lateral portion and the second lateral portion may extend in a first direction perpendicular to a folding axis of the foldable electronic device and be spaced apart from each other in a second direction of the folding axis. The third lateral portion may be spaced apart from the folding axis in the first direction and extend in the second direction. When viewed from above the second display, the printed circuit board is positioned between the battery and the third lateral portion of the first housing. The battery includes a first part including battery cells and a second part including a battery protection circuit. When viewed from above the second display, the second part of the battery is positioned between the first part of the battery and the first lateral portion of the first housing. The second part of the battery is positioned farther away from the second display than the first part of the battery. The display driver integrated circuit may extend in the first direction and overlap the second part of the battery when viewed from above the second display.

### [Advantageous Effects of invention]

A foldable electronic device according to exemplary embodiments of the disclosure can provide an expanded sub-display while maintaining the thinning thereof, thereby improving user satisfaction or usability through a large screen in a folded state thereof.

Further, effects that can be obtained or expected from various embodiments of the disclosure are disclosed directly or implicitly in the detailed description of the embodiments of the disclosure.

### [Brief Description of Drawings]

The above and other aspects, features, and advantages of specific embodiments of the disclosure will become more apparent from the following detailed description taken in conjunction with the accompanying drawings.
FIG. 1 is a diagram illustrating a foldable electronic device in an unfolded state according to an embodiment of the disclosure.
FIG. 2 is a diagram illustrating a foldable electronic device in a folded state according to an embodiment of the disclosure.
FIG. 3 is a cross-sectional view illustrating a foldable electronic device taken along line D-D' of FIG. 1 according to an embodiment of the disclosure.
FIG. 4 is an exploded perspective view illustrating a foldable electronic device according to an embodiment of the disclosure.
FIG. 5 is a diagram illustrating a portion of a foldable electronic device in an unfolded state according to an embodiment of the disclosure.
FIG. 6 is a diagram illustrating a portion of a foldable electronic device according to an embodiment of the disclosure.
FIG. 7 is a cross-sectional view illustrating a portion of a foldable electronic device taken along line E-E' of FIG. 6 according to an embodiment of the disclosure.
FIG. 8 is a diagram illustrating a first battery and a first flexible printed circuit board, and a cross-sectional view illustrating the first battery taken along line G-G' according to an embodiment of the disclosure.
FIG. 9 is a diagram illustrating a portion of a foldable electronic device according to an embodiment of the disclosure.
FIG. 10 is a diagram illustrating a portion of a foldable electronic device according to an embodiment of the disclosure.
FIG. 11 is a cross-sectional view illustrating a portion of a foldable electronic device taken along line H-H' of FIG. 10 according to an embodiment of the disclosure.
FIG. 12 is a cross-sectional view illustrating a portion of a foldable electronic device taken along line I-I' of FIG. 10 according to an embodiment of the disclosure.
FIG. 13 is a cross-sectional view illustrating a portion of a foldable electronic device taken along line J-J' of FIG. 10 according to an embodiment of the disclosure.
FIG. 14 is a cross-sectional view illustrating a portion of a foldable electronic device taken along line K-K' of FIG. 10 according to an embodiment of the disclosure.
FIG. 15 is a cross-sectional view illustrating a portion of a foldable electronic device taken along line L-L' of FIG. 10 according to an embodiment of the disclosure.
FIG. 16 is a perspective view illustrating a portion of a foldable electronic device according to an embodiment of the disclosure.

### [Mode for the Invention]

Hereinafter, various exemplary embodiments of the disclosure are described in more detail with reference to the attached drawings.

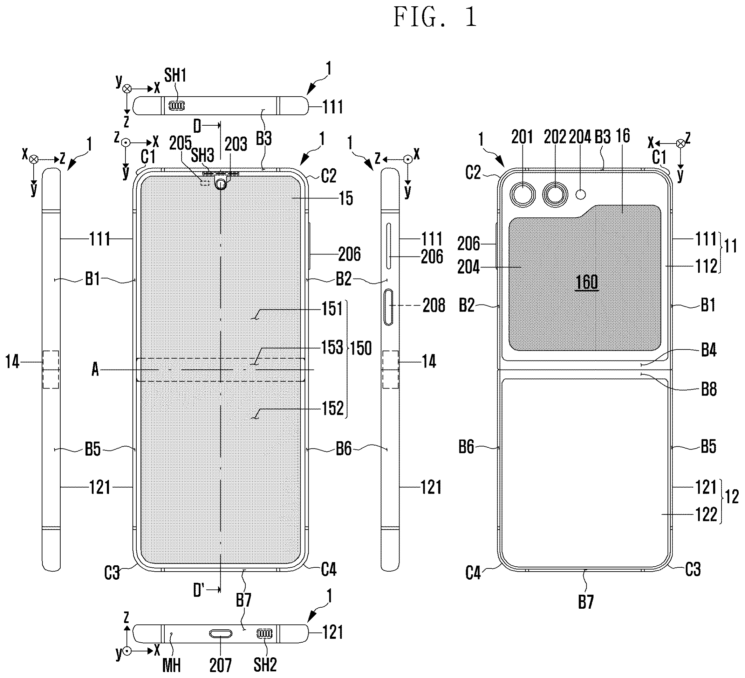

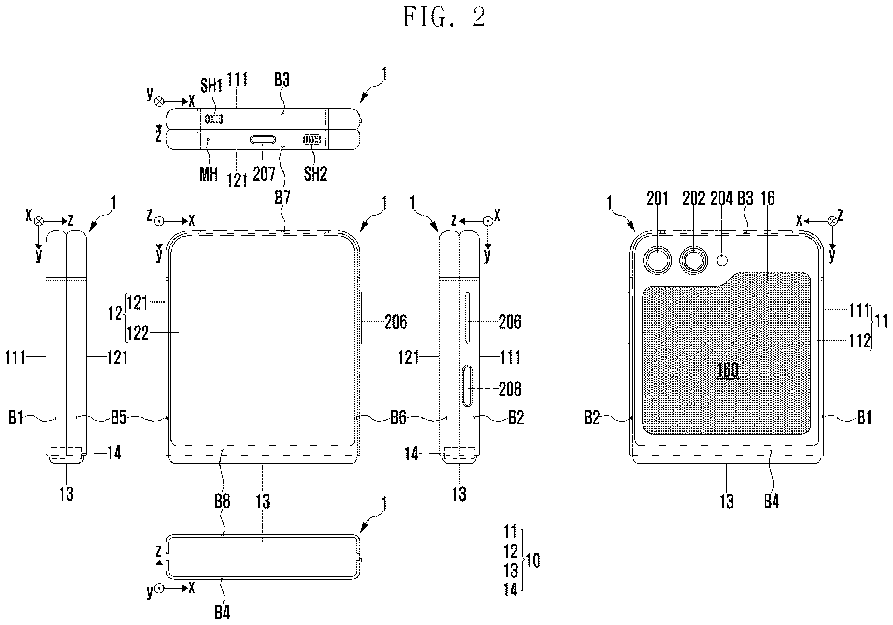

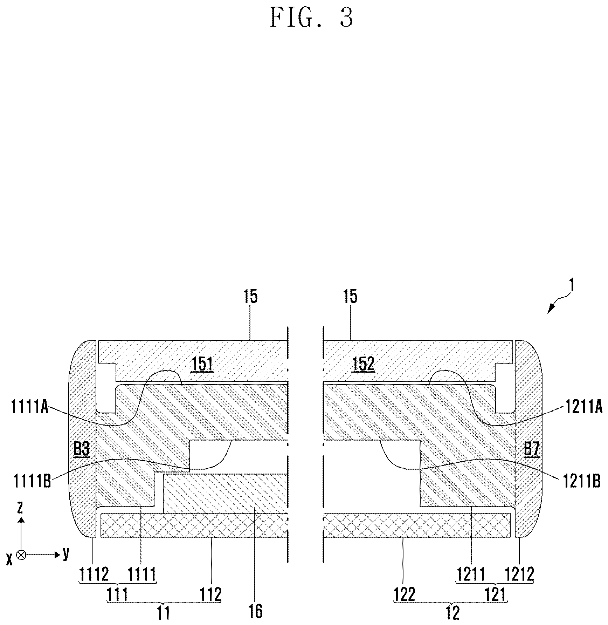

FIG. 1 is a diagram illustrating a foldable electronic device 1 in an unfolded state (also referred to as a flat state) according to an embodiment of the disclosure. FIG. 2 is a diagram illustrating a foldable electronic device 1 in a folded state (also referred to as a folding state) according to an embodiment of the disclosure. FIG. 3 is a cross-sectional view illustrating a foldable electronic device 1 taken along line D-D' of FIG. 1 according to an embodiment of the disclosure.

With reference to FIGS. 1, 2, and 3, the foldable electronic device 1 may include a foldable housing 10, a first display module 15, a second display module 16, a first camera module 201, a second camera module 202, a third camera module 203, a light-emitting module 204, a sensor module 205, an audio input module (not separately illustrated), a first audio output module (not separately illustrated), a second audio output module (not separately illustrated), a third audio output module (not separately illustrated), a key input module, a first connection terminal 207, and/or a second connection terminal 208.

According to an embodiment, an unfolded state and a folded state of the foldable electronic device 1 may be substantially provided by the foldable housing 10. The 'unfolded state of the foldable electronic device 1' and the 'unfolded state of the foldable housing 10 described in the disclosure may be interpreted as being substantially the same. The 'folded state of the foldable electronic device 1' and the 'folded state of the foldable housing 10 described in the disclosure may be interpreted as being substantially the same.

According to an embodiment, the foldable housing 10 may include a first housing (also referred to as a first housing portion or a first housing structure) 11, a second housing (also referred to as a second housing portion or a second housing structure) 12, a hinge housing 13, and/or a hinge portion 14. The first housing 11 and the second housing 12 may be connected via the hinge portion 14. The first housing 11 and the second housing 12 may be rotatable relative to each other about the hinge portion 14. The hinge portion 14 may include, for example, one or more hinge modules (also referred to as hinge assemblies) (not separately illustrated).

According to an embodiment, the first display module 15 may be disposed in the foldable housing 10. The first display module 15 may include, for example, a flexible display module or a foldable display module that may be deformed in response to a switch between an unfolded state and a folded state of the foldable electronic device 1.

According to an embodiment, the first display module 15 may include a first display (e.g., a flexible display or a foldable display) 150 that provides a display area. The display area of the first display 150 may include an active area or a screen area that may display an image based on an electrical signal. The first display 150 may include a first display area 151 corresponding to the first housing 11, a second display area 152 corresponding to the second housing 12, and a third display area 153 corresponding to the hinge portion 14. The third display area 153 may extend the first display area 151 and the second display area 152.

According to an embodiment, the first display area 151 may be disposed in the first housing 11. The shape of the first display area 151 may be maintained by the support of the first housing 11. For example, the first display area 151 may be provided (or formed) to be substantially flat by being supported by the first housing 11. In this specification, in the case where the term "substantially" is used to define a structural part, an expression including the term "substantially" is understood or interpreted as a technical feature produced within the technical tolerance of a method used for manufacturing it. Further, such an expression means that a specific effect or result may be obtained within a specific tolerance, and that a person skilled in the art knows how to obtain such a tolerance.

According to an embodiment, the second display area 152 may be disposed in the second housing 12. The shape of the second display area 152 may be maintained by support of the second housing 12. For example, the second display area 152 may be supported by the second housing 12 and provided (or formed) to be substantially flat.

According to an embodiment, the third display area 153 may be positioned to correspond to the hinge portion 14. When the foldable electronic device 1 is switched between an unfolded state and a folded state, the third display area 153 may be deformed in response to the relative position between the first display area 151 and the second display area 152. In the unfolded state of the foldable electronic device 1, the third display area 153 may be disposed substantially flat. In the folded state of the foldable electronic device 1, the third display area 153 may be disposed in a bent form. The unfolded state of the foldable electronic device 1 may be defined or interpreted as a state in which the third display area 153 is disposed in a flat manner. The folded state of the foldable electronic device 1 may be defined or interpreted as a state in which the third display area 153 is disposed in a bent form.

According to an embodiment, in the unfolded state of the foldable electronic device 1, the first display area 151 and the second display area 152 may form an angle of about 180 degrees, and the first display 150 may be provided (or disposed) in a substantially flat form. In the unfolded state of the foldable electronic device 1, due to relative positions between the first display area 151 disposed in the first housing 11 and the second display area 152 disposed in the second housing 12, the third display area 153 may be disposed in a flat manner. In the unfolded state of the foldable electronic device 1, the third display area 153 may be pulled from both sides by the first display area 151 and the second display area 152, and a tensile force may be provided to allow the third display area 153 to be disposed in a flat manner while reducing breakage of the third display area 153. The third display area 153 may be provided (or formed) with an extended width such that, in the unfolded state of the foldable electronic device 1, it may be disposed in a flat manner with reduced stress while being pulled by the first display area 151 and the second display area 152.

According to an embodiment, the first display 150 of the first display module 15 may substantially define (or form) a front surface of the exterior of the foldable electronic device 1. The front surface of the foldable electronic device 1 may include a first front area provided (or formed) by the first display area 151, a second front area provided (or formed) by the second display area 152, and a third front area provided (or formed) by the third display area 153. The illustrated coordinate axes of the foldable electronic device 1 are illustrated based on, for example, the first housing 11, and the +z-axis direction may be defined or interpreted as the direction in which the substantially flat first front area faces. For example, the first front area provided (or formed) by the first display area 151 may be substantially parallel to the x-y plane. In the unfolded state of the foldable electronic device 1, the front surface of the foldable electronic device 1 may be provided (or formed) as a substantially flat surface.

According to an embodiment, in the unfolded state of the foldable electronic device 1, the hinge portion 14 may support the third display area 153 of the first display module 15 so that it remains substantially flat. The hinge portion 14 may, for example, support the third display area 153 to keep it flat without sagging or with reduced sagging in the unfolded state of the foldable electronic device 1, thereby reducing a crease phenomenon.

According to an embodiment, in the unfolded state of the foldable electronic device 1, in the case where an external force (e.g., an external pressure such as a touch input using a user's finger or a touch input using an electronic pen) is applied to the third display area 153, the hinge portion 14 may support the third display area 153 so as to keep it flat by reducing sagging of the third display area 153.

According to an embodiment, in the case where an external impact, such as one caused by a drop, is applied to the foldable electronic device 1 in the unfolded state, the hinge portion 14 may be configured to reduce or absorb the external impact so as to mitigate its effect on the third display area 153.

According to an embodiment, the foldable electronic device 1 may be implemented in an infolding manner in which the first display 150 of the first display module 15 (or the front surface of the foldable electronic device 1 where the display area of the first display 150 is visually seen) may be folded inward. FIG. 2 illustrates a fully folded state of the foldable electronic device 1 in which the first housing 11 and the second housing 12 are disposed so as not to come any closer to each other. In the fully folded state of the foldable electronic device 1, the first display area 151 and the second display area 152 (or a first front area and a second front area) may face each other. For example, in the fully folded state of the foldable electronic device 1, an angle between the first housing 11 and the second housing 12 (or an angle between the first display area 151 and the second display area 152, or an angle between the first front area and the second front area) may be from about 0 degrees to about 10 degrees. In the fully folded state of the foldable electronic device 1, the first display 150 may be substantially invisible.

Although not separately illustrated, the foldable electronic device 1 may be disposed in an intermediate state between the unfolded state and the fully folded state. For example, in an intermediate state of the foldable electronic device 1 in which an angle between the first housing 11 and the second housing 12 is greater than a certain angle, the foldable electronic device 1 may be configured to provide a usage environment in which a user may use the first display 150.

Hereinafter, the 'folded state of the foldable electronic device 1' of the disclosure may refer to a fully folded state, as distinguished from an intermediate state.

According to an embodiment, in the unfolded state of the foldable electronic device 1, the first display 150 of the first display module 15 may be provided (or formed) in a symmetrical form with respect to a center line A of the foldable electronic device 1. In the unfolded state of the foldable electronic device 1, the center line A of the foldable electronic device 1 may correspond to the middle of the width of the third display area 153 extended from a first boundary between the first display area 151 and the third display area 153 to a second boundary between the second display area 151 and the third display area 153. The illustrated +x coordinate axis may be, for example, substantially parallel to the center line A, and the illustrated +y coordinate axis may be substantially perpendicular to the center line A.

According to various embodiments, the center line A of the foldable electronic device 1 may be defined or interpreted as a 'folding axis' of the foldable housing 10 or the foldable electronic device 1. The folding axis may be substantially provided (or formed) by the hinge portion 14.

According to an embodiment, the third display area 153 disposed in a bent shape in the folded state of the foldable electronic device 1 may be provided (or formed) in a substantially symmetrical shape with respect to the center line A of the foldable electronic device 1.

According to an embodiment, in the unfolded state of the foldable electronic device 1, the display area of the first display 150 included in the first display module 15 may be substantially rectangular.

According to an embodiment, the first housing 11 may include a first frame (also referred to as a first frame structure or a first framework) 111, and a first cover 112 disposed on (or coupled to) the first frame 111. The combination of the first frame 111 and the first cover 112 may define (or form) a first rear area and a first side area of the exterior of the foldable electronic device 1. The first frame 111 may define (or form) at least a portion of the first side area of the foldable electronic device 1. The first cover 112 may define (or form) at least a portion of the first rear area of the foldable electronic device 1. The first rear area may face in a direction opposite to the first front area of the foldable electronic device 1 defined (or formed) by the first display area 151 of the first display module 15.

According to an embodiment, the first frame 111 may include a first side (also referred to as a first lateral member, a first side structure, or a first side bezel structure) 1112. The first side 1112 may surround at least a portion of a space between the first display area 151 and the first cover 112, and define (or form) at least a portion of the first side area of the exterior of the foldable electronic device 1.

According to an embodiment, the first frame 111 may include a first support plate 1111 extended from or connected to the first side 1112. The first support plate 1111 may be a structural element positioned inside the foldable electronic device 1 corresponding to the first housing 11. The first support plate 1111 may also be referred to as a first support portion, a first support, a first bracket, or a first mounting plate.

According to an embodiment, the first frame 111 may be provided (or formed) as an integrated or single structure (e.g., a single continuous structure or a complete structure) including a first support plate 1111 and a first side 1112.

According to an embodiment, the first frame 111 may be provided as a combination of a conductive body (or metal body) (not separately illustrated) including one or more conductive parts and a non-conductive body (or non-metal body) (not separately illustrated) including one or more non-conductive parts.

According to an embodiment, the first support plate 1111 may be positioned at least partially between the first display area 151 and the first cover 112. The first display area 151 may be disposed on the first support plate 1111, and the first support plate 1111 may support the first display area 151.

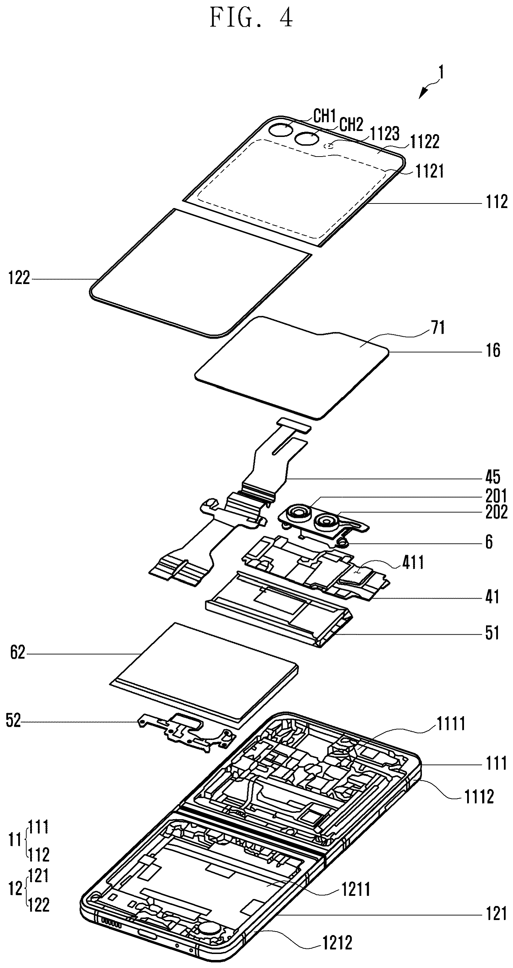

According to an embodiment, various electrical components (not separately illustrated) such as a first printed circuit board 41 (see FIG. 4) or a first battery 51 (see FIG. 4) may be at least partially disposed on the first support plate 1111 of the first frame 111 between the first frame 111 and the first cover 112.

According to an embodiment, electrical components (or electronic parts) or various members related to the electrical components may be disposed on the first frame 111 or the first support plate 1111, or may be supported by the first frame 111 or the first support plate 1111. The first support plate 1111 may include, for example, a first support area (also referred to as a first support surface) 1111A and a third support area (also referred to as a third support surface) 1111B. The first support area 1111A may substantially face the first display area 151 of the first display module 15. The third support area 1111B may be located on an opposite side of the first support area 1111A. The third support area 1111B may substantially face the first cover 112. Electrical components (or electronic parts) or various members related to the electrical components may be disposed in the first support area 1111A and/or the third support area 1111B or supported by the first support area 1111A and/or the third support area 1111B.

According to an embodiment, the first support area 1111A of the first support plate 1111 may provide a first front mounting portion for stably disposing or supporting one or more components, such as the first display area 151 of the first display module 15. The first front mounting portion may be provided, for example, as a combination of surface areas of different heights.

According to an embodiment, the third support area 1111B of the first support plate 1111 may provide a first rear mounting portion for stably disposing or supporting one or more components, such as the first printed circuit board 41 (see FIG. 4) and/or the first battery 51 (see FIG. 4). The first rear mounting portion may be provided, for example, as a combination of surface areas of different heights.

According to an embodiment, the second housing 12 may include a second frame (also referred to as a second frame structure or a second framework) 121, and/or a second cover 122 disposed on the second frame 121. The combination of the second frame 121 and the second cover 122 may define (or form) a second rear area and a second side area of the exterior of the foldable electronic device 1. The second frame 121 may define (or form) at least a portion of the second side area of the foldable electronic device 1. The second cover 122 may define (or form) at least a portion of the second rear area of the foldable electronic device 1. The second rear area may face in an opposite direction to the second front area of the foldable electronic device 1 defined (or formed) by the second display area 152.

According to an embodiment, the second frame 121 may include a second side (also referred to as a second lateral member, a second side structure, or a second side bezel structure) 1212. The second side 1212 may surround at least a portion of a space between the second display area 152 and the second cover 122, and define (or form) at least a portion of the second side area of the exterior of the foldable electronic device 1.

According to an embodiment, the second frame 121 may include a second support plate 1211 extended from or connected to the second side 1212. The second support plate 1211 may be a structural element positioned inside the foldable electronic device 1 corresponding to the second housing 12. The second support plate 1211 may also be referred to as a second support portion, a second support, a second bracket, or a second mounting plate.

According to an embodiment, the second frame 121 may be provided as an integral or single structure (e.g., a single continuous structure or a complete structure) including a second support plate 1211 and a second side 1212.

According to an embodiment, the second frame 121 may be provided as a combination of a conductive body (or metal body) (not separately illustrated) including one or more conductive parts and a non-conductive body (or non-metal body) (not separately illustrated) including one or more non-conductive parts.

According to an embodiment, the second support plate 1211 may be positioned at least partially between the second display area 152 and the second cover 122. The second display area 152 may be disposed on the second support plate 1211, and the second support plate 1211 may support the second display area 152.

According to an embodiment, various electrical components (not separately illustrated) such as a second printed circuit board 42 (see FIG. 4) or a second battery 52 (see FIG. 4) may be at least partially disposed on the second support plate 1211 of the second frame 121 between the second frame 121 and the second cover 122.

According to an embodiment, electrical components (or electronic parts) or various members related to the electrical components may be disposed on or supported by the second frame 121 or the second support plate 1211. The second support plate 1211 may include, for example, a second support area (also referred to as a second support surface) 1211A and a fourth support area (also referred to as a fourth support surface) 1211B. The second support area 1211A may substantially face the second display area 152 of the first display module 15. The fourth support area 1211B may be located on an opposite side of the second support area 1211A. The fourth support area 1211B may substantially face the second cover 122. Electrical components (or electronic parts) or various members related to the electrical components may be disposed on and/or supported by the second support area 1211A and/or the fourth support area 1211B.

According to an embodiment, the second support area 1211A of the second support plate 1211 may provide a second front mounting portion for stably disposing or supporting one or more components such as the second display area 152 of the first display module 15. The second front mounting portion may be provided, for example, as a combination of surface areas of different heights.

According to an embodiment, the fourth support area 1211B of the second support plate 1211 may provide a second rear mounting portion for stably disposing or supporting one or more components such as the second printed circuit board 42 (see FIG. 4) and/or the second battery 52 (see FIG. 4). The second rear mounting portion may be provided, for example, as a combination of surface areas of different heights.

According to an embodiment, the first side 1112 of the first frame 111 may include a first lateral portion B1, a second lateral portion B2, a third lateral portion B3, and/or a fourth lateral portion B4. The first lateral portion B1 may extend in a direction substantially perpendicular to the center line A of the foldable electronic device 1. The second lateral portion B2 may be spaced apart from the first lateral portion B1 in the direction of the center line A of the foldable electronic device 1 and be substantially parallel to the first lateral portion B1. The third lateral portion B3 may extend or connect one end of the first lateral portion B1 and one end of the second lateral portion B2. The fourth lateral portion B4 may extend or connect the other end of the first lateral portion B1 and the other end of the second lateral portion B2. The third lateral portion B3 and the fourth lateral portion B4 may be substantially parallel. The fourth lateral portion B4 may be positioned closer to the center line A of the foldable electronic device 1 than the third lateral portion B3.

According to an embodiment, a first corner C1 where the first lateral portion B1 and the third lateral portion B3 are extended or connected, and/or a second corner C2 where the second lateral portion B2 and the third lateral portion B3 are extended or connected, may be provided (or formed) in a smooth curved shape.

According to an embodiment, when viewed from above the first cover 112, the first lateral portion B1, the second lateral portion B2, the third lateral portion B3, and the fourth lateral portion B4 may surround the first cover 112.

According to an embodiment, the second side 1212 of the second frame 121 may include a fifth lateral portion B5, a sixth lateral portion B6, a seventh lateral portion B7, and/or an eighth lateral portion B8. The fifth lateral portion B5 may extend in a direction substantially perpendicular to the center line A of the foldable electronic device 1. The sixth lateral portion B6 may be spaced apart from the fifth lateral portion B5 in the direction of the center line A of the foldable electronic device 1 and be substantially parallel to the fifth lateral portion B5. The seventh lateral portion B7 may extend or connect one end of the fifth lateral portion B5 and one end of the sixth lateral portion B6. The eighth lateral portion B8 may extend or connect the other end of the fifth lateral portion B5 and the other end of the sixth lateral portion B6. The seventh lateral portion B7 and the eighth lateral portion B8 may be substantially parallel. The eighth lateral portion B8 may be positioned closer to the center line A of the foldable electronic device 1 than the seventh lateral portion B7.

According to an embodiment, a third corner C3 where the fifth lateral portion B5 and the seventh lateral portion B7 are extended or connected, and/or a fourth corner C4 where the sixth lateral portion B6 and the seventh lateral portion B7 are extended or connected, may be provided (or formed) in a smooth curved shape.

According to an embodiment, when viewed from above the second cover 122, the fifth lateral portion B5, the sixth lateral portion B6, the seventh lateral portion B7, and the eighth lateral portion B8 may surround the second cover 122.

According to an embodiment, in the folded state of the foldable electronic device 1, the first side 1112 of the first frame 111 and the second side 1212 of the second frame 121 may be aligned with and overlapped with each other. In the folded state of the foldable electronic device 1, the first lateral portion B1 and the fifth lateral portion B5 may be aligned with and overlapped with each other. In the folded state of the foldable electronic device 1, the second lateral portion B2 and the sixth lateral portion B6 may be aligned with and overlapped with each other. In the folded state of the foldable electronic device 1, the third lateral portion B3 and the seventh lateral portion B7 may be aligned with and overlapped with each other.

According to an embodiment, the first lateral portion B1, the second lateral portion B2, and the third lateral portion B3 may form one side bezel (e.g., a first screen bezel) that surrounds one side region of the first display module 15 with respect to the center line A of the foldable electronic device 1. The fifth lateral portion B5, the sixth lateral portion B6, and the seventh lateral portion B7 may form the other side bezel (e.g., a second screen bezel) that surrounds the other side region of the first display module 15 with respect to the center line A of the foldable electronic device 1.

According to an embodiment, the fourth lateral portion B4 and the eighth lateral portion B8 may be positioned on an opposite side of the third display area 153. When the foldable electronic device 1 is viewed from above the front surface in the unfolded state, the fourth lateral portion B4 and the eighth lateral portion B8 may not be visible.

According to an embodiment, the hinge housing (also referred to as a hinge cover) 13 may be connected to one or more hinge modules (not separately illustrated) included in the hinge portion 14.

According to an embodiment, when the foldable electronic device 1 is switched from an unfolded state to a folded state, a gap between the first frame 111 and the second frame 121 may be opened on an opposite side of the third display area 153 due to a change in relative positions of the first frame 111 and the second frame 121 connected through the hinge portion 14 and a change in the state of the hinge portion 14 coupled to the hinge housing 13. The hinge housing 13 may be exposed to the outside through the open gap. For example, in the folded state of the foldable electronic device 1, the hinge housing 13 may be exposed to the outside through the open gap between the fourth lateral portion B4 of the first frame 111 and the eighth lateral portion B8 of the second frame 121. The width of the gap between the fourth lateral portion B4 of the first frame 111 and the eighth lateral portion B8 of the second frame 121 may vary according to the angle between the first frame 111 and the second frame 121. The hinge housing 13 may be more exposed to the outside in the folded state of the foldable electronic device 1 than in the intermediate state of the foldable electronic device 1. In the folded state of the foldable electronic device 1, the hinge housing 13 may become a part of the exterior that covers the inside of the foldable electronic device 1. In the folded state of the foldable electronic device 1, the side surface of the foldable electronic device 1 may include a first side area provided by the first side 1112 of the first frame 111, a second side area provided by the second side 1212 of the second frame 121, and a third side area provided by the hinge housing 13.

According to an embodiment, when the foldable electronic device 1 is switched from a folded state to an unfolded state, a gap between the first frame 111 and the second frame 121 on an opposite side of the third display area 153 may be closed due to a change in relative positions of the first frame 111 and the second frame 121 connected through the hinge portion 14, and a change in the state of the hinge portion 14 coupled to the hinge housing 13. For example, in the unfolded state of the foldable electronic device 1, a gap between the fourth lateral portion B4 of the first frame 111 and the eighth lateral portion B8 of the second frame 121 may be closed, and the hinge housing 13 may not be exposed to the outside.

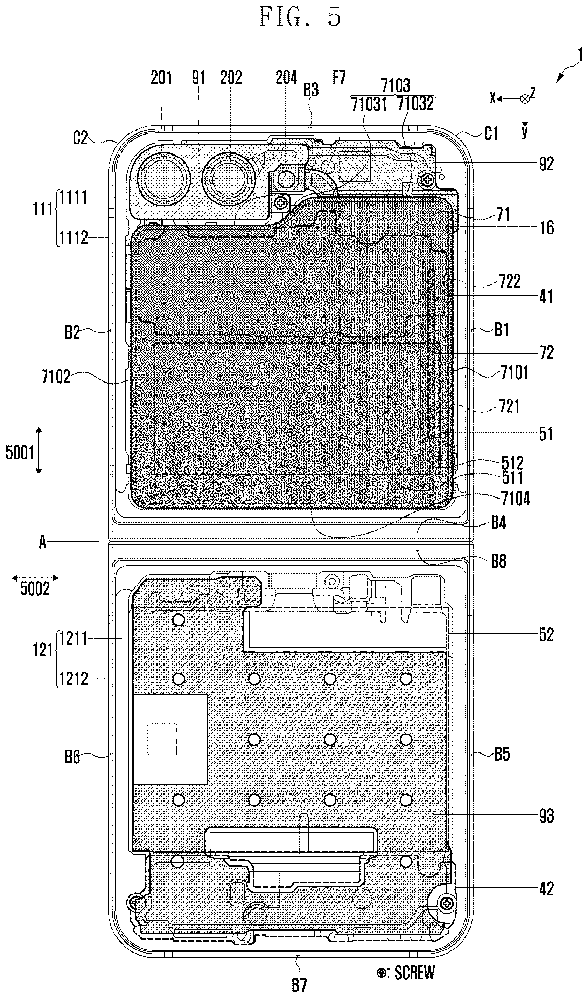

According to an embodiment, the second display module 16 may be positioned between the first cover 112 and the first support plate 1111 of the first frame 111. The second display module 16 may be disposed on or coupled to the first cover 112 and/or the first support plate 1111. The display area 160 of the second display module 16 may be visually seen through the first cover 112. The first cover 112 may include a transparent area (also referred to as a light-transmitting area) 1121 (see FIG. 5) corresponding to the display area 160 of the second display module 16, and an opaque area 1122 (see FIG. 5) surrounding the transparent area 1121. The display area 160 of the second display module 16 may be visually seen through the transparent area 1121 of the first cover 112 (see FIG. 5).

According to an embodiment, the foldable electronic device 1 may be configured to display an image through the second display module 16 instead of the first display module 15 in a folded state.

According to an embodiment, the first camera module 201, the second camera module 202, and/or the third camera module 203 may include one or more lenses, an image sensor(s), and/or an image signal processor (ISP).

According to an embodiment, the first camera module 201 (also referred to as a first camera, a first rear camera module, or a first rear camera) and the second camera module (also referred to as a second camera, a second rear camera module, or a second rear camera) 202 may be accommodated in the first housing 11 corresponding to the first cover 112 (or the first rear area of the foldable electronic device 1). For example, the first cover 112 may include a first camera hole CH1 (see FIG. 5) corresponding to the first camera module 201 and a second camera hole CH2 (see FIG. 5) corresponding to the second camera module 202. The first camera hole CH1 and the second camera hole CH2 may be provided (or formed) in the opaque area 1122 of the first cover 112. The first cover 112 may include a first light-transmitting area (also referred to as a first transparent area) replacing the first camera hole. The first cover 112 may include a second light-transmitting area (also referred to as a second transparent area) replacing the second camera hole. The position or number of camera modules accommodated in the first housing 11 corresponding to the first cover 112 are not limited to the illustrated example and may vary.

According to an embodiment, the first camera module 201 or the second camera module 202 may include a wide-angle camera module, a telephoto camera module, a color camera module, a black-and-white camera module, or an IR camera (e.g., a time of flight (TOF) camera, a structured light camera) module.

According to an embodiment, the first camera module 201 and the second camera module 202 may have different properties (e.g., angle of view) or functions.

According to various embodiments, the first camera module 201 or the second camera module 202 may provide different angles of view (or lenses having different angles of view). The foldable electronic device 1 may selectively use the angle of view of the first camera module 201 or the second camera module 202 based on a user's selection of the angle of view.

According to an embodiment, the third camera module (also referred to as a third camera, a first front camera module, or a first front camera) 203 may be accommodated in the first housing 11 corresponding to the first front area of the foldable electronic device 1.

According to an embodiment, the third camera module 203 may be positioned in alignment with, or at least partially inserted into, an opening provided in the first display module 15. External light may pass through the opening provided in the first display module 15 to reach the third camera module 203. The opening of the first display module 15 that is aligned with or overlaps the third camera module 203 may be a through hole. In various embodiments, the opening of the first display module 15 that is aligned with or overlaps the third camera module 203 may be provided as a notch (not separately illustrated).

According to various embodiments, although not separately illustrated, when viewed from above the first front area of the foldable electronic device 1, the third camera module 203 may overlap the first display area 151 of the first display module 15. The third camera module 203 may be positioned on a rear surface of the first display area 151 or below the first display area 151. When viewed from outside the foldable electronic device 1, the third camera module 203 or the position of the third camera module 203 may not be substantially visually distinguishable (or exposed). The third camera module 203 may include, for example, a hidden display rear camera (e.g., an under display camera (UDC)). External light may pass through the first display module 15 to reach the third camera module 203.

According to various embodiments, the first camera module 201, the second camera module 202, or the third camera module 203 may operate as at least a part of the sensor module. For example, the IR camera module may operate as at least a part of the sensor module.

According to an embodiment, the light-emitting module 204 may be accommodated in the first housing 11 corresponding to the first cover 112 (or the first rear area of the foldable electronic device 1). The first cover 112 may include a fourth light-transmitting area (also referred to as a fourth transparent area) 1123 (see FIG. 4) corresponding to the light-emitting module 204. The fourth light-transmitting area 1123 may be surrounded by the opaque area 1122 (see FIG. 4) of the first cover 112. The first cover 112 may include a flash hole in the form of a through hole instead of the fourth light-transmitting area 1123 (see FIG. 4). The light-emitting module 204 may include, for example, an LED or a xenon lamp. The light-emitting module 204 may include a light source for the first camera module 201 and/or the second camera module 202.

According to various embodiments, the foldable electronic device 1 may further include another light-emitting module (not separately illustrated) accommodated in the foldable housing 10 corresponding to the front surface of the foldable electronic device 1. The light-emitting module may provide status information of the foldable electronic device 1 in the form of light. In various embodiments, the light-emitting module may provide a light source interlinked with the operation of the third camera module 203.

According to an embodiment, the sensor module 205 may be accommodated in the foldable housing 10 corresponding to the front surface of the foldable electronic device 1.

According to an embodiment, the sensor module 205 may include an optical sensor module. The optical sensor module may include, for example, a proximity sensor module or a light sensor module.

According to an embodiment, when viewed from above the first front area of the foldable electronic device 1, the sensor module 205 may overlap the first display area 151 of the first display module 15. The sensor module 205 may be positioned on the rear surface of the first display area 151 or below the first display area 151. When the foldable electronic device 1 is viewed from the outside, the sensor module 205, or the position of the sensor module 205, may not be substantially visually distinguishable (or exposed). External light may pass through the first display module 15 to reach the sensor module 205.

According to various embodiments, the foldable electronic device 1 may further include various other sensor modules (e.g., biometric sensor module) (not separately illustrated).

According to an embodiment, the audio input module may include a microphone (also referred to as a mic) (not separately illustrated). The microphone may be, for example, accommodated in the second housing 12 corresponding to a microphone hole MH included in the seventh lateral portion B7 of the second side 1212. The position or number of the microphone and the microphone hole corresponding to the microphone are not limited to the illustrated example and may vary.

According to an embodiment, the first audio output module may include a first speaker (not separately illustrated). The second audio output module may include a second speaker (not separately illustrated). The first speaker or the second speaker may be a speaker for multimedia playback or playback of recorded audio. The first speaker may be, for example, accommodated in the first housing 11 corresponding to a first speaker hole SH1 included in the third lateral portion B3 of the first side 1112. The second speaker may be, for example, accommodated in the second housing 12 corresponding to a second speaker hole SH2 included in the seventh lateral portion B7 of the second side 1212. The position or number of speakers for multimedia playback or playback of recorded audio, and the position or number of speaker holes corresponding to the speakers, are not limited to the illustrated example and may vary.

According to an embodiment, the third audio output module may include a third speaker (not separately illustrated). The third speaker may include a call receiver. The second speaker may be, for example, accommodated in the first housing 11 corresponding to a third speaker hole SH3 provided between the first display area 151 of the first display module 15 and the third lateral portion B3 of the first side 1112. The position or number of the call speaker and the speaker hole corresponding to the speaker are not limited to the illustrated example and may vary.

According to an embodiment, the key input module may include a key (also referred to as a side key) 206 and a key signal generator (not separately illustrated). For example, the key 206 may be positioned in a key hole included in the second lateral portion B2 of the first side 1112. The key signal generator may be configured to generate a key signal in response to a press or touch on the key 206. The position or number of the key input modules is not limited to the illustrated example and may vary.

According to an embodiment, the first connection terminal 207 (also referred to as a first connector or a first interface terminal) may be accommodated in the second housing 12 corresponding to the first connection terminal hole (e.g., a first connector hole) included in the seventh lateral portion B7 of the second side 1212. The foldable electronic device 1 may transmit and/or receive power and/or data to and from an external electronic device electrically connected to the first connection terminal 207. The first connection terminal 207 may include, for example, a USB connector or an HDMI connector. The positions of the first connection terminal 207 and the first connection terminal hole corresponding thereto are not limited to the illustrated example and may vary.

According to an embodiment, the second connection terminal (also referred to as a second connector or a second interface terminal) 208 may be accommodated in the first housing 11 corresponding to a second connection terminal hole (e.g., a second connector hole) included in the second lateral portion B2 of the first side 1112. An external storage medium such as a secure digital memory (SD) card, a SIM card, or a universal SIM (USIM) may be connected to the second connection terminal 208. The positions of the second connection terminal 208 and the second connection terminal hole corresponding thereto are not limited to the illustrated example and may vary.

The foldable electronic device 1 may further include various components according to its provision form. Although these components cannot all be listed because they may vary according to the convergence trend of the foldable electronic device 1, components equivalent to the above-mentioned components may additionally be included in the foldable electronic device 1. In various embodiments, according to the provision form, certain components among the above-mentioned components may be omitted or replaced with other components.

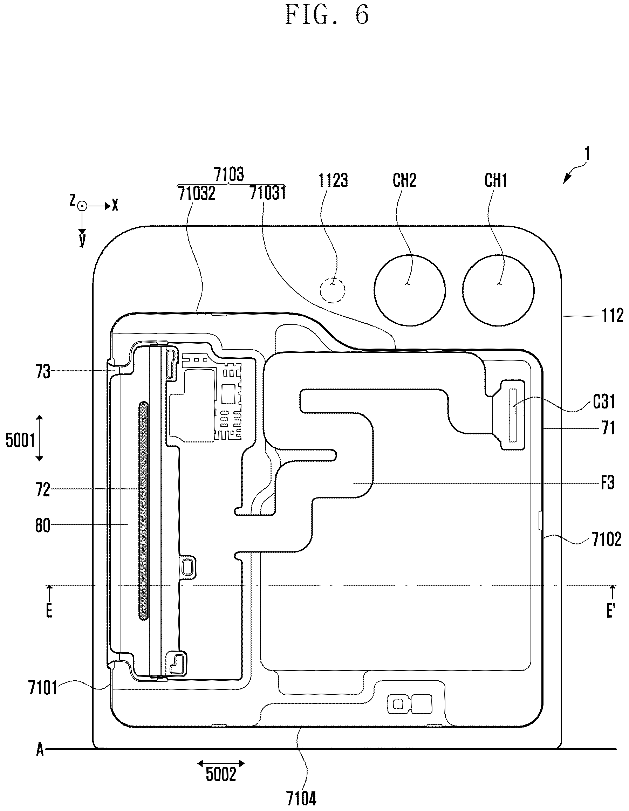

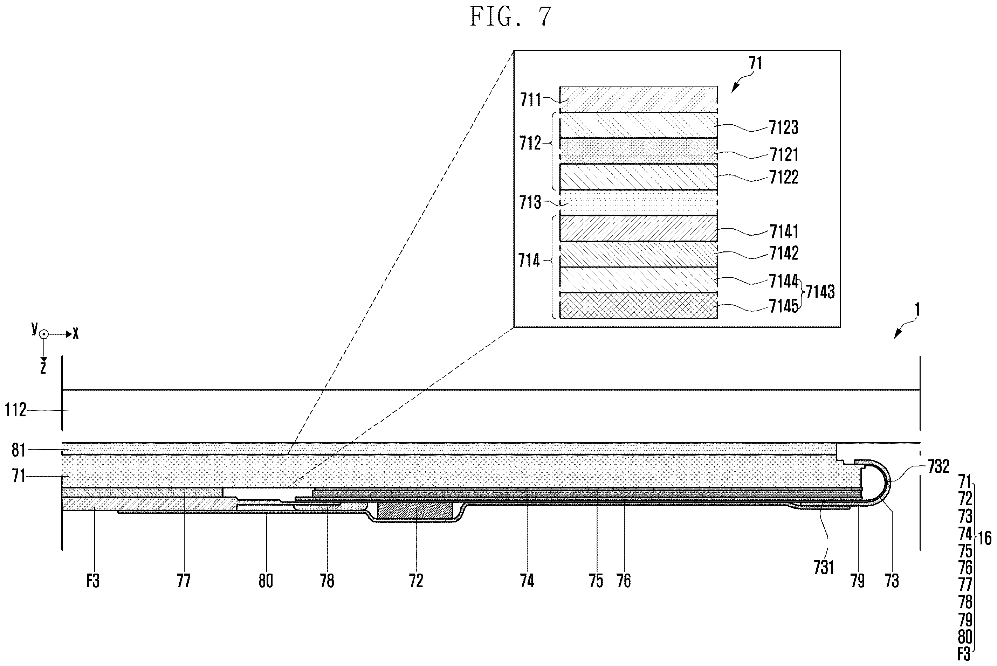

FIG. 4 is an exploded perspective view illustrating a foldable electronic device 1 according to an embodiment of the disclosure. FIG. 5 is a diagram illustrating a portion of a foldable electronic device 1 in an unfolded state according to an embodiment of the disclosure. FIG. 6 is a diagram illustrating a portion of a foldable electronic device 1 according to an embodiment of the disclosure. FIG. 7 is a cross-sectional view illustrating a portion of a foldable electronic device 1 taken along line E-E' of FIG. 6 according to an embodiment of the disclosure.

With reference to FIGS. 4, 5, 6, and 7, the foldable electronic device 1 may include a first housing 11, a second housing 12, a second display module 16, a first printed circuit board 41, a second printed circuit board 42, a first battery 51, a second battery 52, a first camera module 201, a second camera module 202, a camera module bracket (also referred to as a third bracket) 6, a light-emitting module 204, a fourth flexible printed circuit board F4, a seventh flexible printed circuit board F7, a first cover member 91, a second cover member 92, and/or a third cover member 93. Descriptions of some components having the same reference numerals as those illustrated in FIGS. 1, 2, and 3 are omitted.

According to an embodiment, the first housing 11 may include a first frame 111 and a first cover 112. The first frame 111 may include a first support plate 1111 and a first side 1112.

According to an embodiment, the second housing 12 may include a second frame 121 and a second cover 122. The second frame 121 may include a second support plate 1211 and a second side 1212.

According to an embodiment, the second display module 16 may be disposed on or coupled to the first cover 112 via an optically transparent adhesive material (or an optically transparent bonding material) 81. The optically transparent adhesive material (or an optically transparent bonding material) may include, for example, an optical clear adhesive (OCA), an optical clear resin (OCR), or a super view resin (SVR).

According to an embodiment, the second display module 16 may include a second display 71, a display driver integrated circuit (DDI) 72, an extension portion 73, a third flexible printed circuit board F3, a spacer 74, a first adhesive layer (or first bonding layer) 75, a second adhesive layer (or second bonding layer) 76, a third adhesive layer (or third bonding layer) 77, a bonding portion 78, a cover layer 79, and/or a protective sheet 80.

According to an embodiment, the second display 71 may include an optical layer 711, a display panel 712, a base film 713, and/or a lower panel 714.

According to an embodiment, the optical layer 711 may be disposed between the optically transparent adhesive material 81 and the display panel 712. The optical layer 711 may include a polarizing layer (or polarizer) or a retardation layer (or retarder). The polarizing layer and the retardation layer may improve outdoor visibility of the screen. The optical layer 711 may, for example, selectively transmit light generated from a light source of the display panel 712 and oscillating in a particular direction. In various embodiments, a single layer combining the polarizing layer and the retardation layer may be provided, and such a layer may be referred to as a circular polarizing layer.

According to various embodiments, the polarizing layer (or circular polarizing layer) may be omitted. For example, a black pixel define layer (PDL) and/or a color filter may be provided instead of the polarizing layer.

According to an embodiment, the display panel 712 may be disposed between the optical layer 711 and the base film 713. The display panel 712 may include a light-emitting layer 7121, a thin film transistor (TFT) film (also referred to as a TFT substrate) 7122, and/or an encapsulation layer (e.g., thin-film encapsulation (TFE)) 7123.

According to an embodiment, the light-emitting layer 7121 may be disposed between the TFT film 7122 and the encapsulation layer 7123. The light-emitting layer 7121 may include a plurality of pixels implemented with light-emitting elements such as organic light emitting diodes (OLEDs) or micro LEDs. The light-emitting layer 7121 may be disposed on the TFT film 7122 through organic evaporation.

According to an embodiment, the TFT film 7122 may be positioned between the light-emitting layer 7121 and the base film 713. The TFT film 7122 may include a film structure in which at least one TFT is disposed on a flexible substrate (e.g., polyimide (PI) film) through a series of processes such as deposition, patterning, and/or etching. The at least one TFT may control a current to a light-emitting element of the light-emitting layer 7121 to turn a pixel on or off, or to adjust the brightness of the pixel. The at least one TFT may be implemented as, for example, an amorphous silicon (a-Si) TFT, a liquid crystalline polymer (LCP) TFT, a low-temperature polycrystalline oxide (LTPO) TFT, or a low-temperature polycrystalline silicon (LTPS) TFT.

According to an embodiment, the display panel 712 may include a storage capacitor, which may maintain a voltage signal for a pixel, maintain a voltage applied to the pixel within a frame, or reduce a change in gate voltage of a TFT caused by leakage current during a light-emission period. Through a routine for controlling at least one TFT (e.g., initialization, data write), the storage capacitor may maintain a voltage applied to the pixel for a predetermined time interval.

According to an embodiment, the encapsulation layer 7123 may be disposed between the optical layer 711 and the light-emitting layer 7121. The encapsulation layer 7123 may seal the light-emitting layer 341 to prevent oxygen and/or moisture from penetrating into the OLED, thereby reducing or preventing degradation of the OLED's light-emitting characteristics caused by oxygen and/or moisture. The encapsulation layer 7123 may also be referred to as a pixel protection layer for protecting a plurality of pixels of the light-emitting layer 7121.

According to an embodiment, the base film 713 may be disposed between the display panel 712 and the lower panel 714. The base film 713 may support and/or protect the display panel 712. The base film 713 may also be referred to as a protective film, a back film, or a back plate. For example, in the case where the second display 71 is implemented as a rigid display, the base film 713 may be implemented substantially rigidly through a material such as glass. For example, in the case where the second display 71 is implemented as a flexible display, the base film 713 may include a flexible film formed of a polymer or plastic such as PI or polyethylene terephthalate (PET).

According to various embodiments, although not separately illustrated, at least one additional polymer layer (e.g., a layer including PI, PET, or thermoplastic polyurethane (TPU)) may be further disposed on the rear surface of the display panel 712 in addition to the base film 713.

According to an embodiment, the lower panel 714 may include a plurality of layers for various functions. The lower panel 714 may include, for example, a light-shielding layer 7141, a buffer layer 7142, and/or a lower layer 7143. The light-shielding layer 7141 may be disposed between the base film 713 and the buffer layer 7142. The buffer layer 7142 may be disposed between the light-shielding layer 7141 and the lower layer 7143.

According to an embodiment, the light-shielding layer 7141 may block at least part of light incident from the outside. The light-shielding layer 7141 may include, for example, an embossed layer. The embossed layer may be, for example, a black layer including an uneven pattern.

According to an embodiment, the buffer layer 7142 may mitigate an external impact applied to the second display 71. The buffer layer 7142 may include, for example, a sponge layer or a cushion layer.

According to an embodiment, the lower layer 7143 may diffuse, disperse, and/or dissipate heat generated in the foldable electronic device 1 or the second display 71.

According to an embodiment, the lower layer 7143 may absorb and/or shield electromagnetic waves.

According to an embodiment, the lower layer 7143 may mitigate an external impact applied to the foldable electronic device 1 or the second display 71.

According to an embodiment, the lower layer 7143 may include a composite sheet 7144 and/or a metallic sheet (also referred to as a conductive sheet) 7145. The composite sheet 7144 may be disposed between the buffer layer 7142 and the metallic sheet 7145. The composite sheet 7144 may be a sheet formed by combining layers or sheets having different properties. The composite sheet 7144 may include, for example, at least one of polyimide or graphite. The composite sheet 7144 may also be replaced with a single sheet including one material (e.g., polyimide or graphite). The composite sheet 7144 may, for example, diffuse, disperse, and/or dissipate heat generated in the foldable electronic device 1 or the second display 71. The metallic sheet 7145 may form a rear surface of the second display 71. The metallic sheet 7145 may include, for example, a copper sheet, but is not limited thereto and may be made of various other metal materials. The metallic sheet 7145 may reduce, for example, electromagnetic interference (EMI) with respect to the second display 71.

According to various embodiments, although not separately illustrated, at least a portion of the lower layer 7143 may include various conductive members. The various conductive members may include, for example, plates of various metallic materials such as copper, aluminum, or stainless steel. The various conductive members may reinforce the rigidity of the foldable electronic device 1 or the second display module 16. The various conductive members may shield ambient noise. The various conductive members may be used to disperse heat generated from a heat-generating component (e.g., the display driver integrated circuit 72).

According to an embodiment, the lower layer 7143 may include a clad metal. The clad metal may be an integrated or single composite material in which multiple metals are laminated (or bonded). The clad metal may be manufactured through various methods such as welding, pressing, casting, extruding, or laser cladding of multiple metals. The clad metal may provide (or have) a combination of properties (e.g., combined properties) of the multiple metals. Individual properties of the multiple metals may vary and include, for example, electromagnetic, chemical, thermal, or mechanical properties.

According to an embodiment, the lower layer 7143 may include a clad metal in which a first metal layer including stainless steel and a second metal layer including aluminum are laminated. Without being limited thereto, the clad metal may be implemented as a combination of various metal layers.

According to various embodiments, the lower layer 7143 may include various layers for various other functions.

According to various embodiments, at least one of the plurality of layers (e.g., the light-shielding layer 7141, the buffer layer 7142, the composite sheet 7144, and the metallic sheet 7145) included in the lower panel 714 may be omitted.

According to various embodiments, the disposition order of the plurality of layers included in the lower panel 714 is not limited to the illustrated embodiment and may be varied in various ways.

According to various embodiments, although not separately illustrated, the plurality of layers included in the display panel 712 or the lower panel 714, and their stacking structure or stacking order are not limited to the illustrated example and may vary in various ways.

According to an embodiment, the foldable electronic device 1 may include a touch sensing circuit (e.g., touch sensor) (not separately illustrated). The touch sensing circuit may include, for example, a transparent conductive layer (or film) based on various conductive materials such as indium tin oxide (ITO).

According to an embodiment, the touch sensing circuit (not separately illustrated) may be disposed between the first cover 112 and the optical layer 711 as an add-on type.

According to various embodiments, the touch sensing circuit (not separately illustrated) may be disposed between the optical layer 711 and the display panel 712 as an on-cell type.

According to various embodiments, the display panel 712 may include a touch sensing circuit or a touch sensing function as an in-cell type.

According to various embodiments, the second display 71 may include a touch sensing circuit (not separately illustrated) disposed on the encapsulation layer 7123 between the encapsulation layer 7123 and the optical layer 711. The touch sensing circuit may include a conductive pattern such as a metal mesh (e.g., aluminum metal mesh). In response to bending of the second display 71, the metal mesh may have greater durability than a transparent conductive layer implemented with ITO.

According to various embodiments, the second display 71 may further include a pressure sensing circuit (also referred to as a pressure sensor) (not separately illustrated) capable of measuring the intensity (pressure) of a touch.

According to various embodiments, the second display 71 may include an electromagnetic induction panel (e.g., digitizer) (not separately illustrated) that detects a magnetic field-type pen input device (e.g., electronic pen or stylus pen).

According to various embodiments, the second display 71 or the second display module 16 may be implemented by omitting some components or adding other components, according to the form in which it is provided or the convergence trend.

According to an embodiment, the first cover 112 and the second display 71 may be substantially flat and parallel to each other. The term "when viewed from above the first cover 112" as mentioned in the disclosure may be interpreted as being substantially the same as "when viewed from above the second display 71." The term "when viewed from above the first cover 112" as mentioned in the disclosure may refer, for example, to viewing the first rear area of the foldable electronic device 1 provided (or formed) by the first cover 112, in a direction perpendicular to its x-y plane.

According to an embodiment, the display driver integrated circuit 72 may serve as a signal path between the second display 71 and the processor disposed on the first printed circuit board 41. The display driver integrated circuit 72 may control pixels through TFTs included in the second display 71.

According to an embodiment, the display driver integrated circuit 72 may have a function of creating color differences by adjusting amounts of RGB (red, greed, blue) signals of a pixel.

According to various embodiments, the display driver integrated circuit 72 may be configured to operate in response to an RGBW (red, greed, blue, white) method in which a white pixel is added to an RGB pixel.

According to an embodiment, the display driver integrated circuit 72 may include, for example, a DDI or a DDI chip.

According to various embodiments, the display driver integrated circuit 72 may be a DDI package. The display driver integrated circuit 72 may include a DDI (or DDI chip), a timing controller (T-CON), a graphic RAM (GRAM), or power penetrating circuits. In various embodiments, the graphic RAM may be omitted or implemented as a memory provided separately from the display driver integrated circuit 72. The timing controller may convert a data signal input from a processor into a signal required by the DDI. The timing controller may adjust input data information into signals suitable for a gate driver (or gate IC) and a source driver (or source IC) of the DDI. The graphic RAM may serve as a memory that temporarily stores data input to the driver (or IC) of the DDI. The graphic RAM may store the input signal and output it back to the driver of the DDI, and in this case, the graphic RAM may interact with the timing controller to process the signal. The power penetrating circuits may generate a voltage for driving the second display 72 and provide voltages required for the gate driver and the source driver of the DDI.

According to an embodiment, the display driver integrated circuit 72 may be positioned between the second display 71 and the first support plate 1111 of the first frame 111. For example, the display driver integrated circuit 72 may be coupled to the rear surface of the second display 71.

According to an embodiment, the extension portion 73 may extend from the second display 71 or be connected to the second display 71. The extension portion 73 may include electrical paths (e.g., wires implemented as a conductive pattern) that electrically connect the second display 71 and the third flexible printed circuit board F3.

According to an embodiment, the display driver integrated circuit 72 may be disposed in the extension portion 73. For example, the display driver integrated circuit 72 may be disposed on the second display 71 in a chip on panel (COP) method or a chip on film (COF) method.

According to an embodiment, in the COP method, the extension portion 73 may extend from the display panel 712 included in the second display 71. In the COP method, the extension portion 73 may be defined or interpreted as a part of the display panel 712.

According to an embodiment, in the COF method, the extension portion 73 may be a separate flexible film substrate that electrically connects the display panel 712 included in the second display 71 and the third flexible printed circuit board F3.

According to an embodiment, the extension portion 73 or electrical paths included in the extension portion 73 may be provided by the TFT film 7122 based on, for example, LTPS, LTPO, or a-Si technology. In various embodiments, the extension portion 73 may be defined or interpreted as a part of the TFT film 7122.

According to an embodiment, the extension portion 73 may not include pixels. The light-emitting layer 7121 and the encapsulation layer 7123 may not extend into the extension portion 73. In various embodiments, the TFT film 7122 extends into the extension portion 73, but the extension portion 73 may be implemented in a form that does not include any TFT.

According to various embodiments, the light-emitting layer 7121 may extend into the extension portion 73, but the extension portion 73 may be implemented so as not to include a plurality of pixels. In various embodiments, the encapsulation layer 7123 may extend into the extension portion 73.

According to an embodiment, the extension portion 73 may include a first partial extension portion 731 and a second partial extension portion 732. The first partial extension portion 731 may be positioned between the second display 71 and the first support plate 1111 of the first frame 111. The first partial extension portion 731 may be disposed on or coupled to the rear surface of the second display 71. The second partial extension portion 732 may extend from the second display 71 toward the first partial extension portion 731 in a bent form, and be disposed in a bent shape.

According to an embodiment, the display driver integrated circuit 72 may be disposed in the first partial extension portion 731 of the extension portion 73. The display driver integrated circuit 72 may be positioned between the first partial extension portion 731 of the extension portion 73 and the first support plate 1111 of the first frame 111.

According to an embodiment, the display driver integrated circuit 72 may be disposed in the first partial extension portion 731 of the extension portion 73 through tape automated bonding (TAB).

According to an embodiment, a portion of the second display module 16 including the display driver integrated circuit 72 may protrude substantially highest toward the first support plate 1111 of the first frame 111.

According to an embodiment, the second partial extension portion 732 of the extension portion 73 may be positioned corresponding to the first lateral portion B1 of the first frame 111. The second partial extension portion 732 may be bent and extend from the second display 71 to the first partial extension portion 731 on the side of the first lateral portion B1. The second partial extension portion 732 may be disposed in a convex bent shape toward the first lateral portion B1 of the first frame 111.

According to an embodiment, the first lateral portion B1 of the first frame 111 may be spaced apart from the second partial extension portion 732 of the extension portion 73. Securing a separation distance between the first lateral portion B1 and the second partial extension portion 732 may reduce or prevent damage to the second partial extension portion 732 caused by an external impact. For example, in the case where an external impact, such as one caused by a drop, is applied to the foldable electronic device 1, transmission of the external impact to the second partial extension portion 732 through the first lateral portion B1 may be reduced or prevented.

According to an embodiment, the second partial extension portion 732 of the extension portion 73 may be bent with a radius of curvature that may reduce or prevent breakage caused by bending stress. The second partial extension portion 732 may be bent, for example, with a minimum possible radius of curvature while reducing bending stress. For example, a minimized radius of curvature of the second partial extension portion 732 may contribute to achieving a thinner second display module 16.

According to an embodiment, the spacer 74 may be disposed between the second display 71 and the first partial extension portion 731 of the extension portion 73. The spacer 74 may increase a height at which the first partial extension portion 731 of the extension portion 73 is spaced apart from the second display 71 so as to reduce the possibility that the second partial extension portion 732 of the extension portion 73 will be bent to a radius of curvature smaller than a critical radius of curvature (e.g., a radius of curvature at which breakage of the second partial extension portion 732 occurs).

According to an embodiment, the first adhesive layer 75 may be at least partially disposed between the second display 71 and the spacer 74. The spacer 74 and the second display 71 may be coupled via the first adhesive layer 75.

According to an embodiment, the second adhesive layer 76 may be at least partially disposed between the spacer 74 and the first partial extension portion 731 of the extension portion 73. The spacer 74 and the first partial extension portion 731 of the extension portion 73 may be coupled via the second adhesive layer 76.

According to various embodiments, although not separately illustrated, the spacer 74 may be disposed inside the second display 71. The spacer 74 may be defined or interpreted as a component included in the second display 71.

According to an embodiment, the spacer 74 may include a non-metallic material and/or a metallic material.

According to an embodiment, the cover layer 79 may be disposed on or coupled to the extension portion 73. The cover layer 79 may protect the extension portion 73. The cover layer 79 may reinforce the rigidity of the extension portion 73 or improve the durability of the extension portion 73. In the case where an external impact, such as a drop, is applied to the foldable electronic device 1, the cover layer 79 may reduce or prevent damage to the extension portion 73 from the external impact. The cover layer 79 may prevent the extension portion 73 and the first lateral portion B1 of the first frame 111 from directly colliding due to the external impact. The cover layer 79 may include a buffering material that may reduce or absorb the external impact.

According to an embodiment, the cover layer 79 may be a bending protection layer (BPL). The BPL may protect wires included in the extension portion 73.

According to an embodiment, the cover layer 79 may include a non-conductive material (e.g., polymer). The cover layer 79 may include PET, but is not limited thereto.

According to various embodiments, the cover layer 79 may be provided (or formed) as a coating layer disposed on the extension portion 73.

According to an embodiment, the extension portion 73 may be electrically connected to the third flexible printed circuit board F3.

According to an embodiment, the bonding portion 78 where the extension portion 73 and the third flexible printed circuit board F3 are connected may be formed through anisotropic conductive film bonding (ACF bonding). The ACF may be an anisotropic conductive film in which fine conductive particles (e.g., Ni, carbon, or solder balls) are mixed with an adhesive resin (or bonding resin) (e.g., thermosetting resin) to form a film that allows electrical conduction in only one direction. When the ACF is disposed between the extension portion 73 and the third flexible printed circuit board F3 and then compressed by applying heat and pressure, a conductive pattern (not illustrated) provided on the extension portion 73 may be electrically connected to a conductive pattern included in the third flexible printed circuit board F3 through the conductive particles, and the adhesive resin (or bonding resin) may connect the extension portion 73 and the third flexible printed circuit board F3.

According to an embodiment, the third adhesive layer 77 may be disposed between the second display 71 and the third flexible printed circuit board F3. The third flexible printed circuit board F3 and the second display 71 may be coupled via the third adhesive layer 77.

According to an embodiment, the third flexible printed circuit board F3 may be electrically connected to the first printed circuit board 41. The third flexible printed circuit board F3 may include a third connector C31 electrically connected to the first printed circuit board 41. A signal commanded from the processor disposed on the first printed circuit board 41 may be transmitted to the display driver integrated circuit 72 through the third flexible printed circuit board F3.

According to an embodiment, the display driver integrated circuit 72 may include a touch DDI (TDDI). A touch sensor integrated circuit (IC) may be electrically connected to the TDDI and be disposed on the third flexible printed circuit board F3. The touch sensor IC may be electrically connected to a touch sensing circuit (not separately illustrated) included in or disposed on the second display 71.

According to an embodiment, the protective sheet 80 may be positioned at least partially between the second display 71 and the first support plate 1111 of the first frame 111. When viewed from above the first cover 112, the protective sheet 80 may overlap the display driver integrated circuit 72, the extension portion 73, and/or the third flexible printed circuit board F3. The display driver integrated circuit 72 may be disposed between the first partial extension portion 731 of the extension portion 73 and the protective sheet 80. The first partial extension portion 731 of the extension portion 73 may be disposed at least partially between the protective sheet 80 and the second display 71. A portion of the third flexible printed circuit board F3 may be disposed between the protective sheet 80 and the second display 71.

According to an embodiment, the protective sheet 80 may be provided in a form in which at least one conductive layer and at least one insulating layer are laminated.

According to an embodiment, the protective sheet 80 may include a conductive sheet (or conductive layer), and the conductive sheet may reduce electromagnetic interference (EMI) with respect to the display driver integrated circuit 72 and the extension portion 73. The conductive sheet may absorb or shield noise from the outside of the second display module 16. The conductive sheet may reduce electromagnetic effects of noise from the outside of the second display module 16 on the display driver integrated circuit 72. The conductive sheet may reduce electromagnetic effects of noise from the outside of the second display module 16 on electrical paths (e.g., wires implemented with conductive patterns) included in the extension portion 73.

According to an embodiment, the conductive sheet (or conductive layer) included in the protective sheet 80 may reduce the effect of static electricity on electrical paths included in the display driver integrated circuit 72 or the extension portion 73. The conductive sheet may absorb or shield static electricity.

According to an embodiment, the display driver integrated circuit 72 and at least a portion of the extension portion 73 may be disposed between a conductive sheet (or conductive layer) included in the protective sheet 80 and an electromagnetic shielding layer (or electromagnetic absorbing layer) (e.g., the metallic sheet 7145) of the second display 71. The display driver integrated circuit 72 and at least a portion of the extension portion 73 may be disposed so as to be at least partially surrounded by a combination of the conductive sheet of the protective sheet 80 and the electromagnetic shielding layer (or electromagnetic absorbing layer) of the second display 71. The combination of the conductive sheet of the protective sheet 80 and the electromagnetic shielding layer of the second display 71 may provide a shield (or shielding structure) capable of reducing electromagnetic interference with respect to the display driver integrated circuit 72 and the extension portion 73.

According to an embodiment, the bonding portion 78 to which the extension portion 73 and the third flexible printed circuit board F3 are connected may be disposed between the protective sheet 80 and the second display 71.

According to an embodiment, an adhesive material (or bonding material) (not separately illustrated) may be disposed between the second display module 16 and the first support plate 1111 of the first frame 111. The second display module 16 may be coupled to the first support plate 1111 via the adhesive material. The adhesive material may be, for example, disposed at least partially between the protective sheet 80 and the first support plate 1111, and/or between the third flexible printed circuit board F3 and the first support plate 1111.

According to an embodiment, the first printed circuit board 41 and the first battery 51 may be positioned between the first support plate 1111 and the first cover 112. The first printed circuit board 41 and the first battery 51 may be disposed on or coupled to the first support plate 1111. The first printed circuit board 41 may be coupled, for example, to the first support plate 1111 through screw fastening. The first battery 51 may be coupled, for example, to the first support plate 1111 through screw fastening or bonding.

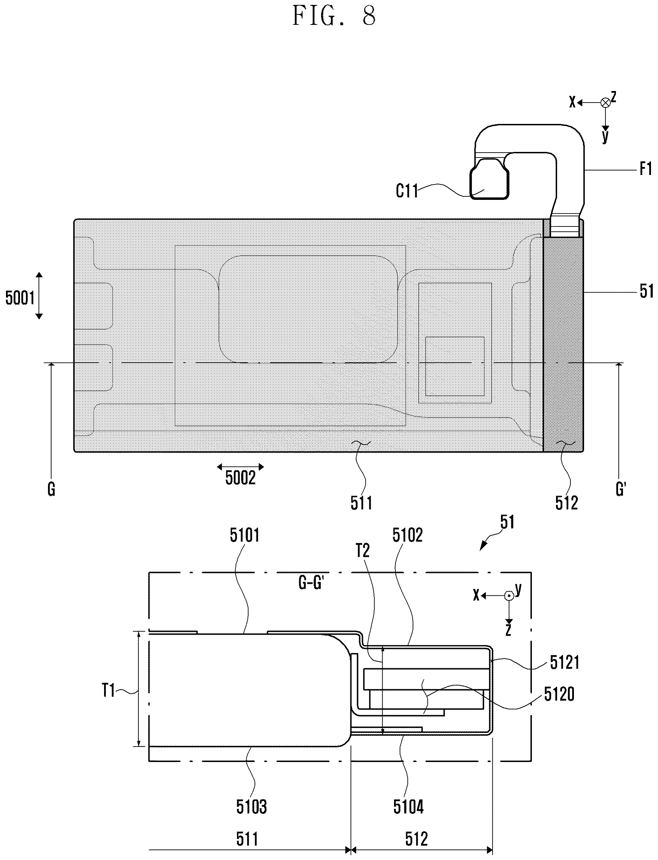

According to an embodiment, the first printed circuit board 41 and the first battery 51 may be electrically connected through the first flexible printed circuit board F1 (see FIG. 8).

According to an embodiment, when viewed from above the first cover 112, the first printed circuit board 41 may be positioned between the first battery 51 and the third lateral portion B3 of the first frame 111. When viewed from above the first cover 112, the first battery 51 may be positioned between the first printed circuit board 41 and the fourth lateral portion B4 of the first frame 111.

According to an embodiment, the first display module 15 (see FIG. 1), the second display module 16, the first camera module 201, the second camera module 202, the third camera module 203 (see FIG. 1), the light-emitting module 204, the sensor module 205 (see FIG. 1), the first audio output module (e.g., a first speaker corresponding to the first speaker hole SH1 of FIG. 1), the third audio output module (e.g., a second speaker corresponding to the third speaker hole SH3 of FIG. 1), the key input module (e.g., a key input module including the key 206 of FIG. 1), and/or the second connection terminal 208 (see FIG. 1) may be electrically connected to the first printed circuit board 41.

According to an embodiment, the second printed circuit board 42 and the second battery 52 may be positioned between the second support plate 1211 and the second cover 122. The second printed circuit board 42 and the second battery 52 may be disposed on or coupled to the second support plate 1211. The second printed circuit board 42 may be coupled, for example, to the second support plate 1211 through screw fastening. The second battery 52 may be coupled to, for example, the second support plate 1211 through screw fastening or bonding.

According to an embodiment, when viewed from above the second cover 122, the second printed circuit board 42 may be positioned between the second battery 52 and the seventh lateral portion B7 of the second frame 121. When viewed from above the second cover 122, the second battery 52 may be positioned between the second printed circuit board 42 and the eighth lateral portion B8 of the second frame 121.

According to an embodiment, the audio input module (e.g., a microphone corresponding to the microphone hole MH of FIG. 1), the second audio output module (e.g., a second speaker corresponding to the second speaker hole SH2 of FIG. 1), and/or the first connection terminal 207 (see FIG. 1) may be electrically connected to the second printed circuit board 42.

According to an embodiment, the fourth flexible printed circuit board F4 may be disposed across the hinge portion 14 (see FIG. 1). The fourth flexible printed circuit board F4 may electrically connect at least one first electrical element accommodated in the first housing 11 and at least one second electrical element accommodated in the second housing 12.

According to an embodiment, the fourth flexible printed circuit board F4 may electrically connect the first printed circuit board 41 and the second printed circuit board 42.

According to an embodiment, the fourth flexible printed circuit board F4 may electrically connect the first printed circuit board 41 and the second battery 52.

According to an embodiment, the first camera module 201 and the second camera module 202 may be positioned between the first support plate 1111 and the first cover 112.

According to an embodiment, the first camera module 201 and the second camera module 202 may be disposed on or coupled to the first support plate 1111 via the camera module bracket 6. The camera module bracket 6 may connect the first camera module 201 and the second camera module 202 to the first support plate 1111. The camera module bracket 6 may be disposed on or coupled to the first support plate 1111 via, for example, screw fastening. The first camera module 201 and/or the second camera module 202 may be coupled to the camera module bracket 6 via mechanical fastening such as screw fastening and/or snap-fit fastening. Snap-fit fastening may be an assembly method in which interlocking elements (e.g., a hook and a hook engaging portion) are elastically pressed together to engage with each other. The camera module bracket 6 disposed on or coupled to the first support plate 1111 may stably support the first camera module 201 and the second camera module 202 with respect to the first support plate 1111.

According to an embodiment, the first camera module 201 and the second camera module 202 may be positioned corresponding to the second corner C2 of the first frame 111. When viewed from above the first cover 112, the first camera module 201 and the second camera module 202 may be positioned closer to the second lateral portion B2 of the first frame 111 than the first lateral portion B1 of the first frame 111. When viewed from above the first cover 112, the first camera module 201 and the second camera module 202 may be positioned closer to the third lateral portion B3 of the first frame 111 than the fourth lateral portion B4 of the first frame 111.

According to an embodiment, when viewed from above the first cover 122, the first camera module 201 and the second camera module 202 may be disposed in a second direction 5002 substantially parallel to the center line (or folding axis) A of the foldable electronic device 1.

According to an embodiment, when viewed from above the first cover 112, the first camera module 201 and the second camera module 202 may not overlap the first printed circuit board 41.

According to an embodiment, the first camera module 201 may be electrically connected to the first printed circuit board 41 via a fifth flexible printed circuit board (not separately illustrated). The second camera module 202 may be electrically connected to the first printed circuit board 41 via a sixth flexible printed circuit board (not separately illustrated).

According to an embodiment, the light-emitting module 204 may be positioned between the first support plate 1111 and the first cover 112.

According to an embodiment, when viewed from above the first cover 112, the second camera module 202 may be positioned between the first camera module 201 and the light-emitting module 204.

According to an embodiment, when viewed from above the first cover 112, the light-emitting module 204 may not overlap the first printed circuit board 41.

According to an embodiment, the light-emitting module 204 may be electrically connected to the first printed circuit board 41 via the seventh flexible printed circuit board F7.

According to an embodiment, when viewed from above the first cover 112, the first cover member 91 may be coupled to the camera module bracket 6 and/or the first support plate 1111 so as to cover and protect the first camera module 201 and the second camera module 202. The first cover member 91 may be coupled, for example, to the camera module bracket 6 and/or the first support plate 1111 via mechanical fastening such as screw fastening or snap-fit fastening. The first cover member 91 may include a first hole corresponding to the lens of the first camera module 201, and a second hole corresponding to the lens of the second camera module 202.

According to an embodiment, the first cover member 91 may be made of a non-conductive material and/or a conductive material.

According to an embodiment, when viewed from above the first cover 112, the second cover member 92 may be coupled to the first support plate 1111 so as to cover and protect one or more components positioned among the first printed circuit board 41, the third lateral portion B3, and the second camera module 202. The second cover member 92 may be coupled to the first support plate 1111 via mechanical fastening, such as, for example, screw fastening or snap-fit fastening.

According to an embodiment, when viewed from above the first cover 112, the second cover member 92 may cover the first audio output module (e.g., a first speaker corresponding to the first speaker hole SH1 of FIG. 1), the third audio output module (e.g., a third speaker corresponding to the third speaker hole SH3 of FIG. 1), and/or the third camera module 203 (see FIG. 1).

According to an embodiment, when viewed from above the first cover 112, the second cover member 92 may cover a first magnet (not separately illustrated) disposed on the first support plate 1111. The first magnet may be aligned with6 a second magnet (not separately illustrated) disposed on the second support plate 1211 of the second frame 121 in a folded state of the foldable electronic device 1. In the folded state of the foldable electronic device 1, the attractive force between the first magnet and the second magnet may reduce occurrence of a gap between the first housing 11 and the second housing 12.

According to various embodiments, one or more components covered and protected by the second cover member 92 may vary.

According to an embodiment, the second cover member 92 may be made of a non-conductive material and/or a conductive material.

According to an embodiment, the light-emitting module 204 may be positioned between the second cover member 92 and the first cover 112. The light-emitting module 204 may be disposed on or coupled to the second cover member 92 via mechanical fastening such as screw fastening or snap-fit fastening, or via bonding.

According to an embodiment, when viewed from above the second cover 122, the third cover member 93 may be coupled to the second support plate 1211 so as to cover and protect a plurality of components disposed on the second support plate 1211. The third cover member 93 may be coupled to the second support plate 1211 via mechanical fastening such as, for example, screw fastening or snap-fit fastening.

According to an embodiment, when viewed from above the second cover 122, the third cover member 93 may cover and protect the second printed circuit board 42, the second battery 44, the audio output module (e.g., a microphone corresponding to the microphone hole MH of FIG. 1), the second audio output module (e.g., a second speaker corresponding to the second speaker hole SH2 of FIG. 1), the first connection terminal 207 (see FIG. 1), and/or the second magnet. One or more components covered and protected by the third cover member 92 may vary.

According to an embodiment, the third cover member 93 may be made of a non-conductive material and/or a conductive material.

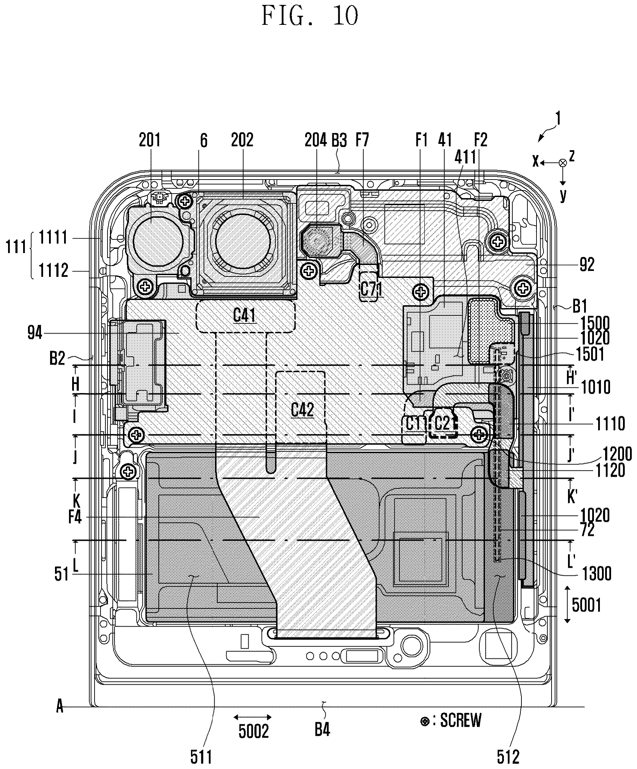

According to an embodiment, the foldable electronic device 1 may include a fourth cover member 94 (see FIG. 10) positioned at least partially between the second display module 16 and the first support plate 1111. The fourth cover member 94 may be coupled to the first support plate 1111 via mechanical fastening such as screw fastening or snap-fit fastening. The fourth cover member 94 may be made of a non-conductive material and/or a conductive material. When viewed from above the first cover 112, the fourth cover member 94 may cover and protect a plurality of components disposed on the first support plate 1111.

According to an embodiment, when viewed from above the first cover 112, the fourth cover member 94 (see FIG. 10) may cover and protect the first printed circuit board 41. One or more components covered and protected by the fourth cover member 94 may vary.

According to an embodiment, when viewed from above the first cover 112, the first cover member 91, the second cover member 92, and the fourth cover member 94 (see FIG. 10) may be disposed so as to reduce overlapping among them without hindering the thinning of the foldable electronic device 1.

According to an embodiment, at least two of the first cover member 91, the second cover member 92, or the fourth cover member 94 (see FIG. 10) may be coupled to the first support plate 1111 via at least one identical screw.

According to an embodiment, the shape and size of the second display 71 may be provided (or formed) so as to reduce interference with peripheral components without hindering the thinning of the foldable electronic device 1.

According to an embodiment, when viewed from above the first cover 112, the second display 71 may not substantially overlap the first cover member 91.

According to an embodiment, when viewed from above the first cover 112, the second display 71 may not substantially overlap the second cover member 92.

According to an embodiment, when viewed from above the first cover 112, the second display 71 may overlap the fourth cover member 94 (see FIG. 10).

According to an embodiment, when viewed from above the first cover 112, the second display 71 may include a first edge 7101, a second edge 7102, a third edge 7103, and/or a fourth edge 7104. When viewed from above the first cover 112, the first edge 7101 may be positioned corresponding to the first lateral portion B1 of the first frame 111. When viewed from above the first cover 112, the second edge 7102 may be positioned corresponding to the second lateral portion B2 of the first frame 111. When viewed from above the first cover 112, the third edge 7103 may be positioned corresponding to the third lateral portion B3 of the first frame 111. When viewed from above the first cover 112, the fourth edge 7104 may be positioned corresponding to the fourth lateral portion B4 of the first frame 111.

According to an embodiment, a first corner edge at which the first edge 7101 and the third edge 7103 are extended or connected, a second corner edge at which the first edge 7101 and the fourth edge 7104 are extended or connected, a third corner edge at which the second edge 7102 and the third edge 7103 are extended or connected, and/or a fourth corner edge at which the second edge 7101 and the fourth edge 7104 are extended or connected may be provided (or formed) in a smooth curved shape.

According to an embodiment, when viewed from above the first cover 112, the first edge 7101 of the second display 71 may extend in a first direction 5001 substantially perpendicular to the center line A of the foldable electronic device 1. When viewed from above the first cover 112, the first edge 7101 may be substantially parallel to the first lateral portion B1 of the first frame 111.

According to an embodiment, when viewed from above the first cover 112, the second edge 7102 of the second display 71 may extend in a first direction 5001 substantially perpendicular to the center line A of the foldable electronic device 1. When viewed from above the first cover 112, the second edge 7102 may be substantially parallel to the second lateral portion B2 of the first frame 111.

According to an embodiment, the third edge 7103 of the second display 71 may include a first partial edge 71031 and a second partial edge 71032. For example, when viewed from above the first cover 112, the first partial edge 71031 may be positioned apart from the third lateral portion B3 of the first frame 111 with the first cover member 91 interposed therebetween. For example, when viewed from above the first cover 112, the second partial edge 71032 may be positioned apart from the third lateral portion B3 of the first frame 111 with the second cover member 92 interposed therebetween.

According to an embodiment, when viewed from above the first cover 112, a separation distance between the first partial edge 71031 of the second display 71 and the third lateral portion B3 of the first frame 111 may be greater than that between the second partial edge 71032 of the second display 71 and the third lateral portion B3 of the first frame 111.

According to an embodiment, when viewed from above the first cover 112, the first partial edge 71031 and the second partial edge 71032 of the second display 71 may extend in a second direction 5002 substantially parallel to the center line A of the foldable electronic device 1. The first partial edge 71031 and the second partial edge 71032 may be smoothly connected.

According to an embodiment, when viewed from above the first cover 112, the fourth edge 7104 of the second display 71 may extend in a second direction 5002 substantially parallel to the center line A of the foldable electronic device 1. When viewed from above the first cover 112, the fourth edge 7104 may be substantially parallel to the fourth lateral portion B4 of the first frame 111.

According to an embodiment, when viewed from above the first cover 112, because distances by which the first partial edge 71031 and the second partial edge 71032 of the third edge 7103 are spaced apart from the third lateral portion B3 of the first frame 111 are different, the first edge 7101 extending from the second partial edge 71032 may be provided (or formed) longer than the second edge 7102 extending from the first partial edge 71031.

According to an embodiment, when viewed from above the first cover 112, the display driver integrated circuit 72 may be positioned toward the first edge 7101 of the second display 71. When viewed from above the first cover 112, the display driver integrated circuit 72 may extend in a first direction 5001 substantially perpendicular to the center line A of the foldable electronic device 1. When viewed from above the first cover 112, the display driver integrated circuit 72 may extend substantially parallel to the first edge 7101 of the second display 71. When viewed from above the first cover 112, the display driver integrated circuit 72 may extend substantially parallel to the first lateral portion B1 of the first frame 111.

According to an embodiment, extending the display driver integrated circuit 72 in the first direction 5001 from the first edge 7101, as compared with extending the display driver integrated circuit 72 in the first direction 5001 from the second edge 7102, may reduce interference between the display driver integrated circuit 72 and peripheral components without hindering the thinning of the foldable electronic device 1.

According to an embodiment, extending the display driver integrated circuit 72 in the first direction 5001 from the first edge 7101, as compared with extending the display driver integrated circuit 72 in the second direction 5002 from the first partial edge 71031 of the third edge 7103 or the second partial edge 71032 of the third edge 713, may reduce interference between the display driver integrated circuit 72 and peripheral components without hindering the thinning of the foldable electronic device 1.

According to an embodiment, extending the display driver integrated circuit 72 in the first direction 5001 from the first edge 7101, as compared with extending the display driver integrated circuit 72 in the second direction 5002 from the first partial edge 71031 of the third edge 7103 or from the second partial edge 71032 of the third edge 713, may reduce wiring constraints on electrical paths such as gate lines or source lines of the second display 71.

According to an embodiment, extending the display driver integrated circuit 72 in the first direction 5001 from the first edge 7101, as compared with extending the display driver integrated circuit 72 in the second direction 5002 from the fourth edge 7104, may reduce interference between the display driver integrated circuit 72 and peripheral components without hindering the thinning of the foldable electronic device 1.

According to an embodiment, the first battery 51 may include a first part 511 and a second part 512. When viewed from above the first cover 112, the first part 511 may be positioned between the second part 512 and the second lateral portion B2 of the first frame 111. When viewed from above the first cover 112, the second part 512 may be positioned between the first part 511 and the first lateral portion B1 of the first frame 111.

According to an embodiment, in a third direction (e.g., z-axis direction) perpendicular to the first direction 5001 and the second direction 5002, a distance (e.g., a gap thickness between the second part 512 and the second display 71) by which the second part 512 of the first battery 51 is spaced apart from the second display 71 may be greater than a distance (e.g., a gap thickness between the first part 511 and the second display 71) by which the first part 511 of the first battery 51 is spaced apart from the second display 71.

According to an embodiment, when viewed from above the first cover 112, the second display 71 may overlap the first part 511 and the second part 512 of the first battery 51.

According to an embodiment, when viewed from above the first cover 112, the display driver integrated circuit 72 may overlap the first battery 51 and the first printed circuit board 41. When viewed from above the first cover 112, the display driver integrated circuit 72 may include a third part 721 overlapped with the first battery 51 and a fourth part 722 overlapped with the first printed circuit board 41.

According to an embodiment, when viewed from above the first cover 112, the display driver integrated circuit 72 may extend in a first direction 5001 substantially perpendicular to the center line A of the foldable electronic device 1 through the first part 511 of the first battery 51 and the first lateral portion B1 of the first frame 111 to overlap the second part 512 of the first battery 51.

According to an embodiment, when viewed from above the first cover 112, overlapping the display driver integrated circuit 72 and the second part 512 of the first battery 51 on the first lateral portion B1 of the first frame 111 may allow securing the size of the second display 71 while reducing interference between the display driver integrated circuit 72 and peripheral components, so as not to hinder thinning of the foldable electronic device 1.

FIG. 8 is a diagram illustrating a first battery 51 and a first flexible printed circuit board F1, and a cross-sectional view of the first battery 51 taken along line G-G' according to an embodiment of the disclosure.

With reference to FIG. 8, the first battery 51 may include a first part 511 and a second part 512.

According to an embodiment, the first part 511 of the first battery 51 may include one or more battery cells. The first part 511 may be implemented to convert chemical energy into electrical energy.

According to an embodiment, the first part 511 of the first battery 51 may include, although not separately illustrated, a pouch (also referred to as a can, case, housing, or outer shell), an electrode assembly, an electrolyte, a positive terminal (also referred to as a positive tab), and a negative terminal (also referred to as a negative tab). The pouch may provide an internal space for accommodating the electrode assembly and the electrolyte. The pouch may be formed of, for example, aluminum or a metal such as aluminum, or a non-metal such as a polymer. The electrode assembly may be formed, for example, by winding a positive plate, a negative plate, and a separator together after stacking them. After the electrode assembly is disposed in an internal space of the pouch, the electrolyte is injected and the pouch is sealed through a series of processes, so that the electrode assembly may be disposed together with the electrolyte in the internal space of the pouch. The positive terminal may be electrically connected to the positive plate. The negative terminal may be electrically connected to the negative plate.

According to an embodiment, the positive electrode plate of the electrode assembly may include a positive electrode substrate and a first composite coated on the positive electrode substrate. The battery capacity and voltage may be determined by the positive electrode plate. The positive electrode substrate may include, for example, a plate or layer (e.g., aluminum foil) including a metal such as aluminum. The first composite may include a positive electrode active material, a conductive agent, and a binder. The positive electrode active material may include a material involved in an electrode reaction (e.g., lithium-based oxide). The conductive agent may include a material for enhancing electrical conductivity. The binder may increase the bonding strength between the positive electrode active material and the conductive agent.

According to an embodiment, the negative electrode plate of the electrode assembly may include a negative electrode substrate and a second composite coated on the negative electrode substrate. The negative electrode substrate may include, for example, a plate or layer (e.g., copper foil) including a metal such as copper. The second composite may include a negative electrode active material, a conductive agent, and a binder. The negative electrode active material may include, for example, a carbon-based material. The conductive agent may include a material for enhancing electrical conductivity. The binder may increase the bonding strength between the negative electrode active material and the conductive agent.

According to an embodiment, the electrolyte of the electrode assembly may include, for example, a material in a liquid, solid, or gel state as a medium that allows ions to move so that the reduction or oxidation reactions of the positive plate and the negative plate are chemically coordinated. For example, during charge of the first battery 51, due to oxidation of the positive plate and reduction of the negative plate, ions (e.g., lithium ions) may be released from the positive plate and move to the negative plate through the electrolyte, and electrons may flow from the positive plate to the negative plate along a circuit (e.g., a power management module, such as a power management integrated circuit (PMIC), disposed on the first printed circuit board 41 of FIG. 4) connected to the positive and negative terminals. For example, during discharge of the first battery 51, due to reduction of the positive plate and oxidation of the negative plate, ions may be released from the negative plate and move to the positive plate through the electrolyte, and electrons may flow from the negative plate to the positive plate along the circuit (e.g., the power management module disposed on the first printed circuit board 41 of FIG. 4) connected to the positive and negative terminals. During discharge, the first battery 51 may convert chemical energy of the positive active material of the positive plate, the negative active material of the negative plate, and the electrolyte into electrical energy, and supply power to the circuit (e.g., the power management module disposed on the first printed circuit board 41 of FIG. 4) through the positive terminal connected to the positive plate and the negative terminal connected to the negative plate.

According to an embodiment, the separator of the electrode assembly may function as an isolation layer disposed between the positive plate and the negative plate to substantially prevent physical contact therebetween. The separator may prevent short-circuiting between the positive plate and the negative plate and allow the movement of ions. For example, the separator may allow the flow of charges by enabling ions to move through microscopic pores and be made of various porous materials.

According to an embodiment, the second part 512 of the first battery 51 may include a cover (also referred to as a cover structure) 5121 and a battery protection circuit 5120 accommodated in the cover 5121. The cover 5121 may cover and protect the battery protection circuit 5120. The cover 5121 may be, for example, implemented to be substantially rigid and be connected to the first part 511 (e.g., a pouch of the first part 511) of the first battery 51.

According to an embodiment, the battery protection circuit 5120 may be electrically connected to the positive terminal and the negative terminal included in the first part 511 of the first battery 51. The battery protection circuit 5120 may stably protect the first part 511 of the first battery 51 that stores energy. The battery protection circuit 5120 may protect and manage the first part 511 of the first battery 51 so that energy can be used safely and efficiently. The battery protection circuit 5120 may protect the first part 511 of the first battery 51 by preventing overcharging, over-discharging, and/or overcurrent.

According to an embodiment, the battery protection circuit 5120 may include a protection circuit module (PCM).

According to an embodiment, when viewed from above the first cover 112 (see FIG. 4), the second part 512 of the first battery 51 may be positioned between the first part 511 of the first battery 51 and the first lateral portion B1 of the first frame 111 (see FIG. 5).

According to an embodiment, the second display 71 (see FIG. 5) of the second display module 16 may overlap the first part 511 and the second part 512 of the first battery 51.

According to an embodiment, in a third direction (e.g., z-axis direction) perpendicular to the first direction 5001 and the second direction 5002, a distance (e.g., a gap thickness between the second part 512 and the second display 71) by which the second part 512 of the first battery 51 is spaced apart from the second display 71 may be greater than a distance (e.g., a gap thickness between the first part 511 and the second display 71) by which the first part 511 of the first battery 51 is spaced apart from the second display 71.

According to an embodiment, the first part 511 of the first battery 51 may include a first surface 5101 and a third surface 5103 that substantially face in opposite directions. The first surface 5101 and the third surface 5103 may be disposed on opposite sides of each other. The first surface 5101 may face the second display 71 (see FIG. 4) of the second display module 16 or the first cover 112 (see FIG. 4). The third surface 5103 may face the first support plate 1111 (see FIG. 4) of the first frame 111. The first part 511 may have a first thickness T1 corresponding to a separation distance between the first surface 5101 and the third surface 5103.

According to an embodiment, the second part 512 of the first battery 51 may include a second surface 5102 and a fourth surface 5104 that substantially face in opposite directions. The second surface 5102 and the fourth surface 5104 may be disposed on opposite sides of each other. The second surface 5102 may face the second display 71 (see FIG. 4) of the second display module 16 or the first cover 112 (see FIG. 4). The fourth surface 5104 may face the first support plate 1111 (see FIG. 4) of the first frame 111. The second part 512 may have a second thickness T2 corresponding to a separation distance between the second surface 5102 and the fourth surface 5104.

According to an embodiment, the first thickness T1 of the first part 511 of the first battery 51 may be greater than the second thickness T2 of the second part 512 of the first battery 51.

According to an embodiment, in a third direction (e.g., z-axis direction) perpendicular to the first direction 5001 and the second direction 5002, the first battery 51 may have a height difference between the first surface 5101 of the first part 511 and the second surface 5102 of the second part 512. A distance by which the second surface 5102 of the second part 512 is spaced apart from the second display 71 (see FIG. 4) of the second display module 16 may be greater than a distance by which the first surface 4101 of the first part 511 is spaced apart from the second display 71 (see FIG. 4) of the second display module 16.

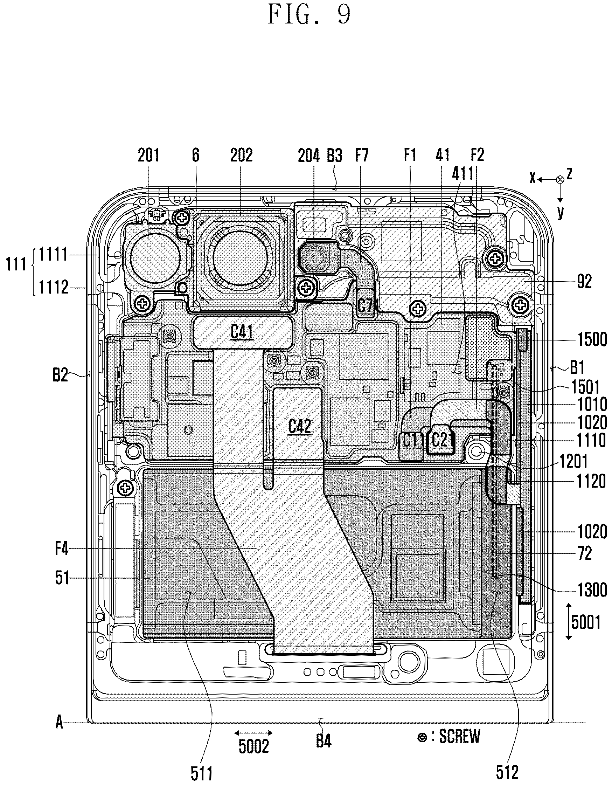

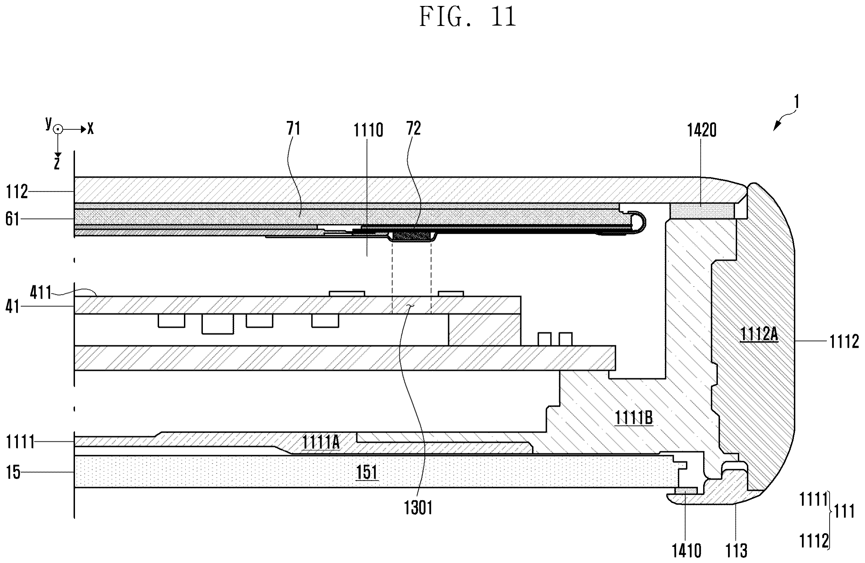

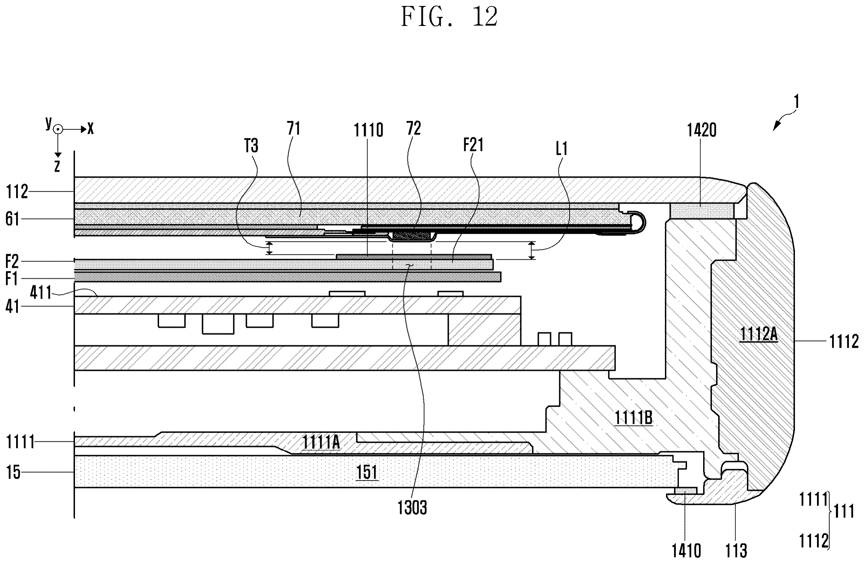

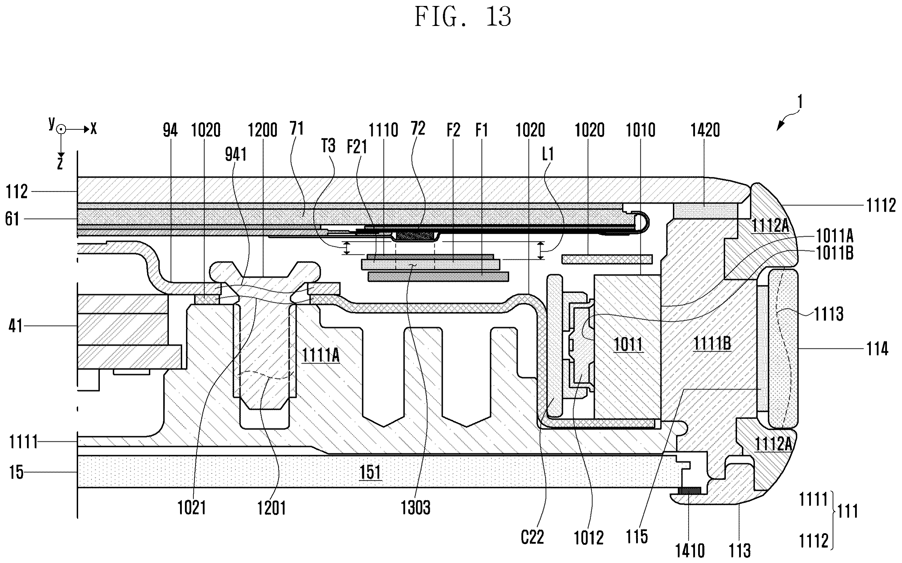

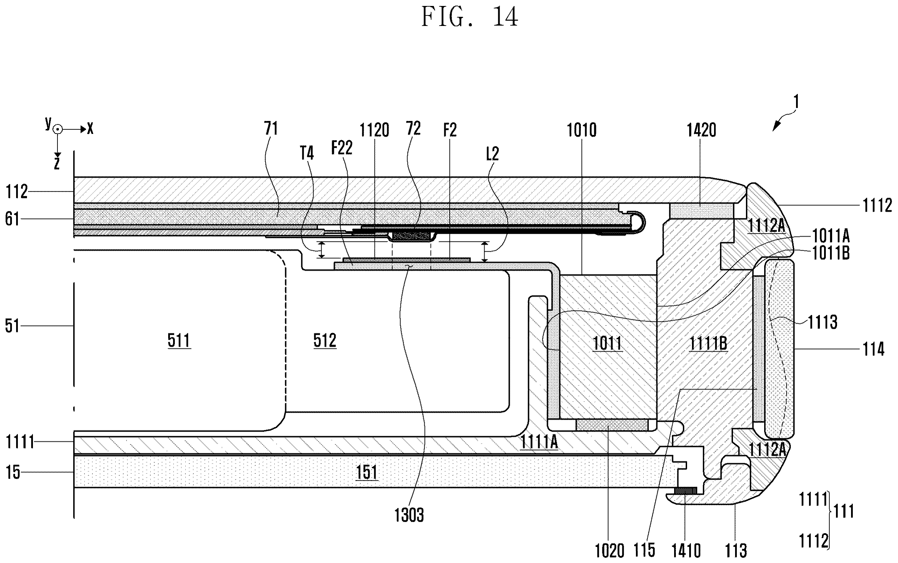

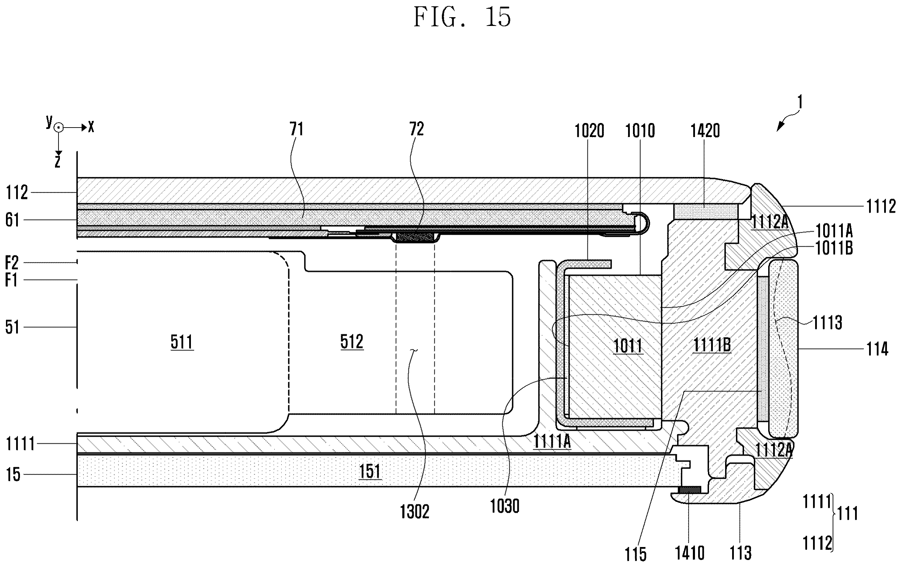

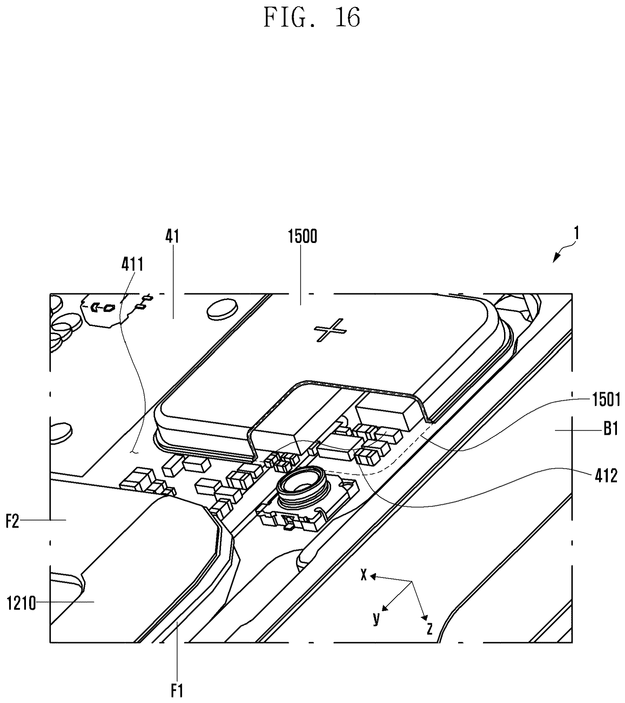

FIG. 9 is a diagram illustrating a portion of a foldable electronic device 1 according to an embodiment of the disclosure. FIG. 10 is a diagram illustrating a portion of a foldable electronic device 1 according to an embodiment of the disclosure. FIG. 11 is a cross-sectional view illustrating a portion of a foldable electronic device 1 taken along line H-H' of FIG. 10 according to an embodiment of the disclosure. FIG. 12 is a cross-sectional view illustrating a portion of a foldable electronic device 1 taken along line I-I' of FIG. 10 according to an embodiment of the disclosure. FIG. 13 is a cross-sectional view illustrating a portion of a foldable electronic device 1 taken along line J-J' of FIG. 10 according to an embodiment of the disclosure. FIG. 14 is a cross-sectional view illustrating a portion of a foldable electronic device 1 taken along line K-K' of FIG. 10 according to an embodiment of the disclosure. FIG. 15 is a cross-sectional view illustrating a portion of a foldable electronic device 1 taken along line L-L' of FIG. 10 according to an embodiment of the disclosure. FIG. 16 is a perspective view illustrating a portion of a foldable electronic device 1 according to an embodiment of the disclosure.

With reference to FIGS. 9, 10, 11, 12, 13, 14, 15, and 16, the foldable electronic device 1 may include a first frame 111, a third frame 113, a non-conductive portion 114, a first display module 15, a second display module 16, a first camera module 201, a second camera module 202, a light-emitting module 204, a camera module bracket 6, a second cover member 92, a fourth cover member 94, a first printed circuit board 41, a first battery 51, an antenna module 1010, an antenna module bracket (also referred to as a fourth bracket) 1020, a first flexible printed circuit board F1, a second flexible printed circuit board F2, a fourth flexible printed circuit board F4, a seventh flexible printed circuit board F7, a first elastic member (or first flexible member) 1110, and/or a second elastic member (or second flexible member) 1120. Descriptions of some components having the same reference numerals as those illustrated in FIGS. 1, 2, 3, 4, 5, 6, 7, and 8 are omitted.

According to an embodiment, the first side 1112 of the first frame 111 may include a first metal (also referred to as an outer metal) 1112A. The first metal 1112A may define (or form) at least a portion of a first side area included in the first housing 11 (see FIG. 1) of the exterior of the foldable electronic device 1. According to an embodiment, the first support plate 1111 of the first frame 111 may include a second metal (also referred to as an inner metal) 1111A and a non-metal 1111B connected to the second metal 1111A.

According to an embodiment, the first metal 1112A of the first side 1112 included in the first frame 111 may include a plurality of metal areas (also referred to as metal parts) (not separately illustrated) that are physically separated from each other. For example, when viewed from above the first cover 112, the plurality of metal areas may be disposed along an edge of the first cover 112. The first metal 1112A may include a plurality of segments between the plurality of conductive parts. The first side 1112 may include a plurality of non-metal areas (also referred to as non-metal parts) (not separately illustrated) disposed in the plurality of segments. At least some of the plurality of metal areas may be connected to the second metal 1111A of the first support plate 1111. For example, an integral or single metal structure (e.g., a single continuous metal structure or a complete metal structure) including at least a portion of the plurality of metal areas and the second metal 1111A of the first support plate 1111 may be provided (or formed). The plurality of non-metal areas may be connected to the non-metal 1111B of the first support plate 1111. For example, an integral or single non-metal structure (e.g., a single continuous non-metal structure or a complete non-metal structure) including the plurality of non-metal areas and the non-metal 1111B of the first support plate 1111 may be provided (or formed).

According to an embodiment, the second frame 121 (see FIG. 1) may be implemented in a manner substantially identical to or at least partially similar to the first frame 111.

According to an embodiment, the third frame 113 may be disposed on or coupled to the first frame 111. The third frame 113 may cover a first border (also referred to as a first border area, a first rim, or a first rim area) (not separately illustrated) extending from the first display area 151 of the first display module 15. The foldable electronic device 1 may include a fourth frame (not separately illustrated). The fourth frame may cover a second border (also referred to as a second border area, a second rim, or a second rim area) (not separately illustrated) extending from the second display area 152 (see FIG. 1) of the first display module 15. The foldable electronic device 1 may include a first flexible cover member (not separately illustrated) and a second flexible cover member. The first flexible cover member may cover a third border (also referred to as a third border area, a third rim, or a third rim area) (not separately illustrated) on one side, the third border extending from the third display area 153 (see FIG. 1) of the first display module 15. The second flexible cover member may cover a fourth border (also referred to as a fourth border area, a fourth rim, or a fourth rim area) (not separately illustrated) on the other side, the fourth border extending from the third display area 153 (see FIG. 1) of the first display module 15. The third border and the fourth border may extend from the first border and the second border. The first border, the second border, the third border, and the fourth border may include a non-active area, a non-display area, or a non-screen area that does not include pixels.

According to an embodiment, the foldable electronic device 1 may include a first sealing member 1410 disposed between the third frame 113 and the first border of the first display module 15. The first sealing member 1410 may reduce or prevent external foreign substances, such as moisture or dust, from entering the internal space of the foldable electronic device 1 through the space between the first border of the first display module 15 and the third frame 113. The first sealing member 1410 may include, for example, an elastic member or a flexible member, such as rubber, a brush, or a sponge. The first sealing member 1410 may include, for example, an adhesive material (or bonding material) connecting the third frame 113 and the first border of the first display module 15.

According to an embodiment, the foldable electronic device 1 may include a second sealing member 1420 disposed between the first cover 112 and the first support plate 1111. The second sealing member 1420 may reduce or prevent external foreign substances, such as moisture or dust, from entering the internal space of the foldable electronic device 1 through the space between the first cover 112 and the first support plate 1111. The second sealing member 1420 may include, for example, an adhesive material (or bonding material) connecting the first cover 112 and the first support plate 1111.

According to an embodiment, the first flexible printed circuit board F1 may electrically connect the first printed circuit board 41 and the first battery 51. The first flexible printed circuit board F1 may be electrically connected to the battery protection circuit 5120 (see FIG. 8) included in the second part 512 of the first battery 51. The first flexible printed circuit board F1 may include a first connector C11 electrically connected to the first printed circuit board 41.

According to an embodiment, when viewed from above the first cover 112, the first flexible printed circuit board F1 may overlap the first printed circuit board 41. For example, when viewed from above the first cover 112, the first connector C11 of the first flexible printed circuit board F1 may be positioned between the second cover member 92 and the first part 511 of the first battery 51. For example, when viewed from above the first cover 112, the first connector C11 may be positioned closer to the first battery 51 than the second cover member 92.

According to an embodiment, the antenna module 1010 may be accommodated in the first housing 11 (see FIG. 1) corresponding to the first lateral portion B1 of the first frame 111. For example, the antenna module 1010 may be positioned closer to the first lateral portion B1 than the second lateral portion B2 of the first frame 111.

According to an embodiment, an electromagnetic wave transmitted (or radiated) from the antenna module 1010 may pass through the first lateral portion B1 and propagate to the outside of the foldable electronic device 1. An electromagnetic wave transmitted from the outside of the foldable electronic device 1 may pass through the first lateral portion B1 and be received (or detected) by the antenna module 1010.

According to an embodiment, the antenna module 1010 may be configured to transmit and/or receive signals in a millimeter-wave frequency band.

According to an embodiment, the antenna module 1010 may include an antenna structure, communication circuitry (or wireless communication circuitry) (not separately illustrated), power management circuitry (not separately illustrated), and/or an electromagnetic shield (not separately illustrated).

According to an embodiment, the antenna structure of the antenna module 1010 may include a third printed circuit board 1011. The third printed circuit board 1011 may include a fifth surface 1011A and a sixth surface 1011B facing in an opposite direction to the fifth surface 1011A. The fifth surface 1011A A and the sixth surface 1011B may be, for example, substantially parallel. The fifth surface 1011A may face the first lateral portion B1.

According to an embodiment, a direction in which the fifth surface 1011A of the third printed circuit board 1011 of the antenna module 1010 faces may be substantially parallel to a direction of the center line A of the foldable electronic device 1 (e.g., the second direction 5002).

According to an embodiment, the third printed circuit board 1011 of the antenna module 1010 may include a plurality of pattern layers including a conductive pattern, and a plurality of non-conductive layers (e.g., insulating layers) alternately laminated with the plurality of pattern layers.

According to an embodiment, the third printed circuit board 1011 of the antenna module 1010 may include a plurality of conductive vias (not separately illustrated). The conductive via may be a conductive hole provided to allow placement of a connecting wire for electrically connecting conductive patterns of different pattern layers. The conductive via may include, for example, a plated through hole (PTH), a laser via hole (LVH), a buried via hole (BVH), or a stacked via. At least one conductive via may electrically connect, for example, signal line patterns (e.g., patterns of conductive lines utilized as electrical paths) included in different pattern layers as part of a signal line. At least one conductive via may electrically connect, for example, ground planes (or ground areas or ground patterns) included in different pattern layers.

According to an embodiment, the third printed circuit board 1011 of the antenna module 1010 may include an antenna array. The antenna array may be implemented, for example, with some conductive patterns among a plurality of pattern layers included in the third printed circuit board. The antenna array may be disposed on the fifth surface 1011A of the third printed circuit board 1011, or may be disposed within the third printed circuit board 1011 closer to the fifth surface 1011A than the sixth surface 1011B. The antenna array may include a plurality of antenna elements.

According to an embodiment, a plurality of antenna elements of the antenna module 1010 may have substantially the same shape and be disposed at regular intervals. The plurality of antenna elements may be disposed in the first direction 5001 substantially parallel to the center line A of the foldable electronic device 1 when viewed from above the fifth surface 1011A of the third printed circuit board 1011 (e.g., when viewed in the +x-axis direction).

According to an embodiment, the third printed circuit board 1011 of the antenna module 1010 may include a ground plane that acts as an antenna ground. The ground plane may be disposed, for example, closer to the sixth surface 1011B of the third printed circuit board 1011 than the antenna array. The ground plane may contribute to securing antenna radiation performance (or radio transmission and reception performance or communication performance) and/or coverage with respect to the antenna array. The ground plane may reduce electromagnetic interference (or signal loss) with respect to the antenna array.

According to an embodiment, the third printed circuit board 1011 of the antenna module 1010 may extend from a region between the second part 512 of the first battery 51 and the first lateral portion B1 of the first frame 111 to a region between the first printed circuit board 41 and the first lateral portion B of the first frame 111.

According to an embodiment, when viewed from above the first cover 112, the second display 71 may overlap the third printed circuit board 1011 of the antenna module 1010.

According to an embodiment, the communication circuitry of the antenna module 1010 may be disposed on the sixth surface 1011B of the third printed circuit board 1011 via a conductive adhesive material (or conductive bonding material) (not separately illustrated) such as solder. The communication circuitry may be electrically connected to the antenna array via wires (or electrical paths) (not separately illustrated) included in the third printed circuit board 1011.

According to an embodiment, the communication circuitry of the antenna module 1010 may include a radio frequency integrated circuit (RFIC).

According to various embodiments, the communication circuitry may be disposed on the first printed circuit board 41. The communication circuitry may be omitted from the antenna module 1010.

According to an embodiment, the communication circuitry of the antenna module 1010 may up-convert or down-convert the frequency of a signal to be transmitted or received. The communication circuitry of the antenna module 1010 may receive an intermediate frequency (IF) signal from wireless communication circuitry disposed on the first printed circuit board 41 and up-convert the received IF signal to a radio frequency (RF) signal (e.g., millimeter wave). The communication circuitry of the antenna module 1010 may down-convert an RF signal received through the antenna array to an IF signal, and the IF signal may be provided to the wireless communication circuitry disposed on the first printed circuit board 41.

According to an embodiment, the communication circuitry of the antenna module 1010 may be configured to transmit and/or receive signals of substantially the same frequency band (or frequency) through the antenna array.

According to an embodiment, the communication circuitry of the antenna module 1010 may be configured to transmit and/or receive signals in at least a portion of frequency bands of about 3 GHz to about 100 GHz via the antenna array.

According to an embodiment, the power management circuitry of the antenna module 1010 may be disposed on the sixth surface 1011B of the third printed circuit board 1011 via a conductive adhesive material (or conductive bonding material) (not separately illustrated) such as solder. The power management circuitry may be electrically connected to the communication circuitry or various other components (e.g., passive elements) disposed on the third printed circuit board 1011 via wires (or electrical paths) (not separately illustrated) included in the third printed circuit board 1011. The power management circuitry may include a power management integrated circuit (PMIC).

According to various embodiments, the power management circuitry may be disposed on the first printed circuit board 41. The power management circuitry may be omitted from the antenna module 1010.

According to an embodiment, an electromagnetic shield of the antenna module 1010 may be disposed on the third printed circuit board 1011 so as to at least partially surround communication circuitry, power management circuitry, or other various electrical elements disposed on the sixth surface 101 1B of the third printed circuit board 1011. The electromagnetic shield may be electrically connected to a ground plane included in the third printed circuit board 1011. The combination of the electromagnetic shield and the ground plane may be defined or interpreted as a ground structure of the antenna module 1010. The ground structure may reduce electromagnetic interference (e.g., electromagnetic noise) with respect to a plurality of electrical elements, such as communication circuitry and power management circuitry. The electromagnetic shield may include a conductive member such as a shield can. The electromagnetic shield may include, for example, a protective member such as a urethane resin, and conductive paint such as EMI paint applied to an outer surface of the protective member. The electromagnetic shield may be provided (or formed) as, for example, various shielding sheets.

According to an embodiment, the antenna module 1010 may include a frequency tuning circuit or a matching circuit disposed on the third printed circuit board 1011. The frequency tuning circuit or matching circuit may include, for example, a tuner or a passive element. The frequency tuning circuit or matching circuit may perform impedance matching or shift a resonant frequency to a designated frequency or by a designated amount.

According to an embodiment, the foldable electronic device 1 may include a radio frequency (RF) window area (or electromagnetic wave transparent area) corresponding to the antenna module 1010. An electromagnetic wave transmitted (or radiated) from the antenna module 1010 may pass through the RF window area and propagate to the outside of the foldable electronic device 1. An electromagnetic wave transmitted from the outside of the foldable electronic device 1 may pass through the RF window area and be received (or detected) by the antenna module 1010. The RF window area may be positioned to correspond at least in part to coverage (or beam coverage) (e.g., communication range) of the antenna module 1010. The RF window area may include a non-conductive member and/or an air gap.

According to an embodiment, when viewed from above the fifth surface 1011A of the third printed circuit board 1011 of the antenna module 1010, the RF window area may overlap at least partially with the fifth surface 1011A. The RF window area may be implemented to reduce an impact on the antenna radiation performance (or radio wave transmission and reception performance) and/or coverage (or beam coverage) of the antenna module 1010. The RF window area may have a permittivity that may reduce an electromagnetic impact on the antenna module 1010. The RF window area may have a permittivity that may reduce degradation of the antenna radiation performance of the antenna module 1010, or may have a permittivity that does not degrade the antenna radiation performance below a critical level. The RF window area may have a permittivity that affects the coverage of the antenna module 1010 within an allowable range, or may have a permittivity that does not substantially affect the coverage of the antenna module 1010. The permittivity in the RF window area may be a value that may reduce the difference with the permittivity of air (e.g., low permittivity).

According to various embodiments, the RF window area may include a dielectric lens (or electromagnetic lens) or may be implemented to operate as a dielectric lens. The dielectric lens may focus and/or diverge electromagnetic waves in a manner similar to an optical lens refracting light waves. The dielectric lens may secure or improve the antenna radiation performance and/or coverage of the antenna module 1010.

According to an embodiment, the first side 1112 of the first frame 111 may include an opening (also referred to as a radiation hole) 1113 provided (or formed) in the first metal 1112A. An electromagnetic wave transmitted (or radiated) from the antenna module 1010 may pass through the opening 1113 and propagate to the outside of the foldable electronic device 1. An electromagnetic wave transmitted from the outside of the foldable electronic device 1 may pass through the opening 1113 and be received (or detected) by the antenna module 1010.

According to an embodiment, the non-conductive portion 114 may be positioned in the opening 1113 provided (or formed) in the first metal 1112A of the first side 1112. The non-conductive portion 114 may form a first side area of the foldable electronic device 1 together with the first metal 1112A. When viewed from above the fifth surface 1011A of the third printed circuit board 1011 of the antenna module 1010, the non-conductive portion 114 may overlap the antenna array of the antenna module 1010. The non-conductive portion 114 may be included in an RF window area corresponding to the antenna module 1010. Electromagnetic waves transmitted (or radiated) from the antenna module 1010 may pass through the non-conductive portion 114 located in the opening 1113 and propagate to the outside of the foldable electronic device 1. Electromagnetic waves transmitted from the outside of the foldable electronic device 1 may pass through the non-conductive portion 114 disposed in the radiation hole and be received (or detected) by the antenna module 1010.

According to an embodiment, the opening 1113 of the first metal 1112A may be a through hole. The through hole may be, for example, an opening entirely surrounded by the conductive area.

According to various embodiments, when viewed from above the first lateral portion B1, the opening 1113 of the first metal 1112A may be provided (or formed) in the form of a notch (not separately illustrated) recessed from the first display area 151 of the first display module 15 toward the first cover 112.

According to various embodiments, when viewed from above the first lateral portion B1, the opening 1113 of the first metal 1112A may be provided (or formed) in the form of a notch (not separately illustrated) recessed from the first cover 112 toward the first display area 151 of the first display module 15.

According to various embodiments, when viewed from above the first lateral portion B1, the opening 1113 of the first metal 1112A may be provided (or formed) as a segment (not separately illustrated) that physically separates two metal areas of the first metal 1112A.

According to an embodiment, a portion of the non-metal 1111B of the first support plate 1111 may be positioned between the third printed circuit board 1011 and the non-conductive portion 114 of the antenna module 1010. The third printed circuit board 1011 may transmit and/or receive a signal (e.g., a signal in the millimeter wave band) through a portion of the non-metal 1111B positioned between the third printed circuit board 1011 and the non-conductive portion 114, and the non-conductive portion 114 positioned in the opening 1113 of the first metal 1112A. A portion of the non-metal 1111B positioned between the third printed circuit board 1011 and the non-conductive portion 114 may be included in an RF window area corresponding to the antenna module 1010.

According to an embodiment, the non-conductive portion 114 located in the opening 1113 of the first metal 1112A may be coupled to the non-metal 1111B via an adhesive material (or bonding material) 115. The adhesive material 115 may be included in an RF window area corresponding to the antenna module 1010.

According to an embodiment, the antenna module 1010 may be disposed on or coupled to the first support plate 1111 of the first frame 111 via the antenna module bracket 1020. The antenna module bracket 1020 may connect the antenna module 1010 to the first support plate 1111. The antenna module bracket 1020 may be disposed on or coupled to the first support plate 1111 via, for example, screw fastening. The antenna module 1010 may be coupled to the antenna module bracket 1020 via an adhesive material (or bonding material) 1030. The antenna module 1010 may be coupled to the antenna module bracket 1020 via mechanical fastening, such as, for example, screw fastening and/or snap-fit fastening. The antenna module bracket 1020 disposed on or coupled to the first support plate 1111 may stably support the antenna module 1010 with respect to the first support plate 1111.

According to an embodiment, the antenna module bracket 1020 may be made of a non-conductive material and/or a conductive material.

According to an embodiment, the antenna module bracket 1020 may reinforce the rigidity of the antenna module 1010. The antenna module bracket 1020 may reduce transmission of external impacts to the antenna module 1010.

According to an embodiment, the antenna module bracket 1020 may reduce electromagnetic interference with respect to the antenna module 1010. The antenna module bracket 1020 may absorb and/or shield electromagnetic noise.

According to an embodiment, the antenna module bracket 1020 may diffuse, disperse, and/or dissipate heat generated by the antenna module 1010. The heat generated by the antenna module 1010 may be diffused or dispersed toward the first frame 111 through the antenna module bracket 1020.

According to an embodiment, the second flexible printed circuit board F2 may electrically connect the first printed circuit board 41 and the antenna module 1010. The second flexible printed circuit board F2 may include a second connector C21 electrically connected to a connector disposed on the seventh surface (a surface facing the first cover 112) 411 of the first printed circuit board 41, and a sixth connector C22 electrically connected to a connector 1012 disposed on the sixth surface 1011B of the third printed circuit board 1011 included in the antenna module 1010.

According to an embodiment, when viewed from above the first cover 112, the second flexible printed circuit board F2 may overlap the first printed circuit board 41 and the second part 512 of the first battery 51.

According to an embodiment, the second part 512 of the first battery 51 may support the second flexible printed circuit board F2.

According to an embodiment, when viewed from above the first cover 112, the second connector C21 of the second flexible printed circuit board F2 may be positioned between the second cover member 92 and the first part 511 of the first battery 51. For example, when viewed from above the first cover 112, the second connector C21 may be positioned closer to the first battery 51 than the second cover member 92.

According to an embodiment, when viewed from above the first cover 112, the second connector C21 of the second flexible printed circuit board F2 may be positioned between the first connectors C11 of the first flexible printed circuit board F1.

According to an embodiment, when viewed from above the first cover 112, the first flexible printed circuit board F1 and the second flexible printed circuit board F2 may be positioned between the fourth flexible printed circuit board F4 and the first lateral portion B1 of the first frame 111.

According to an embodiment, when viewed from above the first cover 112, the second flexible printed circuit board F2 may overlap the first flexible printed circuit board F1. For example, a portion of the first flexible printed circuit board F1 may be positioned between the first printed circuit board 41 and the second flexible printed circuit board F2.

According to an embodiment, when viewed from above the first cover 112, the display driver integrated circuit 72 may overlap the first flexible printed circuit board F1 and the second flexible printed circuit board F2.

According to an embodiment, when viewed from above the first cover 112, the foldable electronic device 1 may include a display driver integrated circuit overlapping portion 1300 that faces and overlaps the display driver integrated circuit 72. The display driver integrated circuit overlapping portion 1300 may be provided (or formed) by a combination of one or more electrical components (e.g., electronic parts) and/or one or more structural components.

According to an embodiment, the display driver integrated circuit overlapping portion 1300 may be provided (or formed) as a combination of surface areas of different heights and/or surface areas of the same height through a combination of one or more components. For example, in a third direction (e.g., the z-axis direction) perpendicular to the first direction 5001 and the second direction 5002, a distance by which a certain part of the display driver integrated circuit overlapping portion 1300 is spaced apart from the display driver integrated circuit 72 may be different from a distance by which another part of the display driver integrated circuit overlapping portion 1300 is spaced apart from the display driver integrated circuit 72. For example, in the third direction, a distance by which a certain part of the display driver integrated circuit overlapping portion 1300 is spaced apart from the display driver integrated circuit 72 and a distance by which another part of the display driver integrated circuit overlapping portion 1300 is spaced apart from the display driver integrated circuit 72 may be substantially the same.

According to an embodiment, the display driver integrated circuit overlapping portion 1300 may include a second part 512 of the first battery 51.

According to an embodiment, the display driver integrated circuit overlapping portion 1300 may include a seventh surface 411 of the first printed circuit board 41 facing the first cover 112.

According to an embodiment, the display driver integrated circuit overlay 1300 may include at least one component (e.g., an electrical component or a structural component) disposed on the seventh surface 411 of the first printed circuit board 41.

According to an embodiment, the display driver integrated circuit overlay 1300 may include a second flexible printed circuit board F2.

According to an embodiment, when viewed from above the first cover 112, the display driver integrated circuit overlapping portion 1300 may include a first overlapping area 1301 included in the first printed circuit board 41, a second overlapping area 1302 included in the second part 512 of the first battery 51, and a third overlapping area 1303 included in the second flexible printed circuit board F2. When viewed from above the first cover 112, the third overlapping area 1303 may be positioned between the first overlapping area 1301 and the second overlapping area 1302 in the first direction 5001.

According to an embodiment, in a third direction (e.g., z-axis direction) perpendicular to the first direction 5001 and the second direction 5002, a separation distance between the display driver integrated circuit 72 and the second overlapping area 1302 may be greater than a separation distance between the display driver integrated circuit 72 and the first overlapping area 1301 and a separation distance between the display driver integrated circuit 72 and the third overlapping area 1303. A sagging amount (or sagging displacement) or bending stress caused by an external impact or load may be generated most significantly in a portion of the display driver integrated circuit 72 corresponding to the second overlapping area 1302.

According to an embodiment, the foldable electronic device 1 may include an air gap between the display driver integrated circuit 72 and the display driver integrated circuit overlapping portion 1300. The air gap may be interpreted as substantially not including any material capable of transmitting an impact or load.

According to an embodiment, the air gap between the display driver integrated circuit 72 and the display driver integrated circuit overlapping portion 1300 may reduce or prevent damage to the display driver integrated circuit 72 from an external impact or load. The air gap between the display driver integrated circuit 72 and the display driver integrated circuit overlapping portion 1300 may also reduce stress that may occur in the display driver integrated circuit 72 due to an external impact or load. For example, in the case where an external impact or load is applied to at least a portion of the first cover 112 that overlaps the display driver integrated circuit 72, the air gap between the display driver integrated circuit 72 and the display driver integrated circuit overlapping portion 1300 does not substantially include a material capable of transmitting the impact or load; thus, compared with a comparative example in which the air gap is substantially absent, the impact or load transmitted to the display driver integrated circuit 72 may be reduced or prevented.

According to an embodiment, the air gap between the display driver integrated circuit 72 and the display driver integrated circuit overlapping portion 1300 may mitigate an external impact or load. For example, in the case where an external impact or load is applied to at least a portion of the first cover 112 that overlaps the display driver integrated circuit 72, the air gap between the display driver integrated circuit 72 and the display driver integrated circuit overlapping portion 1300 may allow the display driver integrated circuit 72 to sag through the air gap, thereby reducing stress concentration on the display driver integrated circuit 72. In a comparative example in which the air gap between the display driver integrated circuit 72 and the display driver integrated circuit overlapping portion 1300 is substantially absent, in the case where an external impact or load is applied to at least a portion of the first cover 112 that overlaps the display driver integrated circuit 72, stress concentration may occur on the display driver integrated circuit 72 due to the support provided by the display driver integrated circuit overlapping portion 1300. In the comparative example, in the case where at least a portion of the display driver integrated circuit overlapping portion 1300 has substantially greater rigidity than the display driver integrated circuit 72, when an external impact or load is applied to at least the portion of the first cover 112 that overlaps the display driver integrated circuit 72, stress concentration on the display driver integrated circuit 72 may become more severe.

According to an embodiment, the thickness of the air gap between the display driver integrated circuit 72 (or the portion of the protective sheet 80 in FIG. 7 that covers the display driver integrated circuit 72) and the display driver integrated circuit overlapping portion 1300 in a third direction (e.g., the z-axis direction) perpendicular to the first direction 5001 and the second direction 5002 may be provided (or formed) to a value that may reduce or prevent damage to the display driver integrated circuit 72 from an external impact or load without hindering the thinning of the foldable electronic device 1.

According to an embodiment, the thickness of the air gap between the display driver integrated circuit 72 (or the portion of the protective sheet 80 in FIG. 7 that covers the display driver integrated circuit 72) and the display driver integrated circuit overlapping portion 1300 may be formed to a value that allows the display driver integrated circuit overlapping portion 1300 to restrict bending of the display driver integrated circuit 72 so that the display driver integrated circuit 72 does not bend to an extent at which it may be damaged when it bends through the air gap due to an external impact or load. Restricting the display driver integrated circuit 72 from bending beyond a certain extent may mean preventing generation of bending stress (e.g., yield stress) that may cause breakage or permanent deformation of the display driver integrated circuit 72. Due to bending (e.g., sagging) of the display driver integrated circuit 72 and support provided by the display driver integrated circuit overlapping portion 1300 against an external impact or load, stress concentration on the display driver integrated circuit 72 may be reduced or prevented.

According to an embodiment, the air gap between the display driver integrated circuit 72 (or the portion of the protective sheet 80 in FIG. 7 that covers the display driver integrated circuit 72) and the display driver integrated circuit overlapping portion 1300 may be provided (or formed) with a thickness of about 0.3 mm to about 0.4 mm.

According to an embodiment, the foldable electronic device 1 may include at least one intervening member (also referred to as an intervening portion) interposed in the air gap between the display driver integrated circuit 72 (or the portion of the protective sheet 80 in FIG. 7 that covers the display driver integrated circuit 72) and the display driver integrated circuit overlapping portion 1300. The at least one intervening member may reduce the thickness of the air gap between the display driver integrated circuit 72 (or the portion of the protective sheet 80 in FIG. 7 that covers the display driver integrated circuit 72) and the display driver integrated circuit overlapping portion 1300, thereby restricting bending of the display driver integrated circuit 72 to an extent that it may be damaged through the air gap due to an external impact or load.

According to an embodiment, at least one intervening member positioned between the display driver integrated circuit 72 (or the portion of the protective sheet 80 in FIG. 7 that covers the display driver integrated circuit 72) and the display driver integrated circuit overlapping portion 1300 may include a rigid member or an elastic member.

According to an embodiment, at least one intervening member positioned between the display driver integrated circuit 72 (or the portion of the protective sheet 80 in FIG. 7 that covers the display driver integrated circuit 72) and the display driver integrated circuit overlapping portion 1300 may include an impact-absorbing material (also referred to as a cushioning material). The at least one intervening member may include, for example, a first elastic member 1110 and a second elastic member 1120. The first elastic member 1110 and the second elastic member 1120 may reduce the thickness of the air gap between the display driver integrated circuit 72 (or the portion of the protective sheet 80 in FIG. 7 that covers the display driver integrated circuit 72) and the display driver integrated circuit overlapping portion 1300, thereby mitigating an external impact or load while restricting bending of the display driver integrated circuit 72 to an extent that it may be damaged through the air gap due to the external impact or load.

According to an embodiment, the first elastic member 1110 and the second elastic member 1120 may be positioned between the display driver integrated circuit 72 (or the portion of the protective sheet 80 in FIG. 7 that covers the display driver integrated circuit 72) and the second flexible printed circuit board F2. The first elastic member 1110 and the second elastic member 1120 may be disposed on or coupled to the second flexible printed circuit board F2. The first elastic member 1110 and the second elastic member 1120 may be coupled to the second flexible printed circuit board F2 via, for example, an adhesive material (or bonding material).

According to an embodiment, the first elastic member 1110 and/or the second elastic member 1120 may include a sponge, but is not limited thereto.

According to an embodiment, when viewed from above the first cover 112, the second flexible printed circuit board F2 may include a first area F21 and a second area F22. When viewed from above the first cover 112, the first area F21 may overlap the first printed circuit board 41. When viewed from above the first cover 112, the second area F22 may overlap the second part 512 of the first battery 51. The first elastic member 1110 may be disposed on or coupled to the first area F21. The second elastic member 1220 may be disposed on or coupled to the second area F22. When viewed from above the first cover 112, the first elastic member 1110 and the second elastic member 1120 may not overlap.

According to an embodiment, when viewed from above the first cover 112, the first area F21 of the second flexible printed circuit board F2 may overlap the first printed circuit board 41. When viewed from above the first cover 112, the second area F22 of the second flexible printed circuit board F2 may overlap the second part 512 of the first battery 51.

According to an embodiment, in a third direction (e.g., the z-axis direction) perpendicular to the first direction 5001 and the second direction 5002, the first area F21 of the second flexible printed circuit board F2 and the display driver integrated circuit 72 (or the portion of the protective sheet 80 in FIG. 7 that covers the display driver integrated circuit 72) may be spaced apart by a first distance L1. In the third direction, the second area F22 of the second flexible printed circuit board F2 and the display driver integrated circuit 72 (or the portion of the protective sheet 80 in FIG. 7 that covers the display driver integrated circuit 72) may be spaced apart by a second distance L2.

According to an embodiment, the first distance L1 and the second distance L2 may be different.

According to an embodiment, the second distance L2 may be greater than the first distance L1. The second flexible printed circuit board F2 may be used in an assembly process of the foldable electronic device 1 with the first elastic member 1110 and the second elastic member 1120 attached thereto. A portion of the second flexible printed circuit board F2 between the first area F21, where the first elastic member 1110 is disposed, and the second area F22, where the second elastic member 1120 is disposed, may be disposed in a bent state. In a comparative example in which the second flexible printed circuit board F2 is used in the assembly process of the foldable electronic device 1 with an integral or single elastic member attached thereto to replace the first elastic member 1110 and the second elastic member 1120, a portion of the second flexible printed circuit board between the first area F21 and the second area F22 may be difficult to bend due to the integral or single elastic member.

According to an embodiment, the second distance L2 may be smaller than the first distance L1. A portion of the second flexible printed circuit board F2 between the first area F21, where the first elastic member 1110 is disposed, and the second area F22, where the second elastic member 1120 is disposed, may be disposed in a bent state.

According to an embodiment, the first distance L1 and the second distance L2 may be substantially the same. The first area F21 and the second area F22 of the second flexible printed circuit board F2 may be disposed with substantially no difference in height. An integral elastic member replacing the first elastic member 1110 and the second elastic member 1120 may be disposed on the second flexible printed circuit board F2.

According to an embodiment, the first distance L1 and the second distance L2 may be about 0.3 mm to 0.5 mm, but are not limited thereto.

According to an embodiment, in a third direction (e.g., z-axis direction) perpendicular to the first direction 5001 and the second direction 5002, a first air gap between the first elastic member 1110 and the display driver integrated circuit 72 (or the portion of the protective sheet 80 in FIG. 7 that covers the display driver integrated circuit 72) may have a third thickness T3. In the third direction, a second air gap between the second elastic member 1120 and the display driver integrated circuit 72 (or the portion of the protective sheet 80 in FIG. 7 that covers the display driver integrated circuit 72) may have a fourth thickness T4.

According to an embodiment, in the third direction, the first elastic member 1110 and the second elastic member 1120 may have substantially the same thickness, and the fourth thickness T4 of the second air gap may be greater than the third thickness T3 of the first air gap.

According to an embodiment, in the third direction, the first elastic member 1110 and the second elastic member 1120 may have substantially the same thickness, and the third thickness T3 of the first air gap may be greater than the fourth thickness T4 of the second air gap.

According to an embodiment, in the third direction, the second elastic member 1120 may be provided (or formed) to be thicker than the first elastic member 1110 such that the third thickness T3 of the first air gap becomes substantially the same as the fourth thickness T4 of the second air gap.

According to various embodiments, the first elastic member 1110 may have a thickness that substantially eliminates an air gap between the display driver integrated circuit 72 (or the portion of the protective sheet 80 in FIG. 7 that covers the display driver integrated circuit 72) and the second flexible printed circuit board F2.

According to various embodiments, the second elastic member 1120 may have a thickness that substantially eliminates an air gap between the display driver integrated circuit 72 (or the portion of the protective sheet 80 in FIG. 7 that covers the display driver integrated circuit 72) and the second flexible printed circuit board F2.

According to various embodiments, in the case where the antenna module 1010, the antenna structure 1020, and the second flexible printed circuit board F2 are omitted, or where the second flexible printed circuit board F2 is positioned so as not to overlap the first flexible printed circuit board F1, the first elastic member 1110 and/or the second elastic member 1120 may be disposed on or coupled to the first flexible printed circuit board F1.

According to an embodiment, when viewed from above the first cover 112, the fourth flexible printed circuit board F4 may be disposed across the first battery 51. The fourth flexible printed circuit board F4 may include a fourth connector C41 and/or a fifth connector C42. The fourth connector C41 and the fifth connector C42 may be electrically connected to respective ones of two connectors disposed on the seventh surface 411 of the first printed circuit board 41.

According to an embodiment, the seventh flexible printed circuit board F7 may include a seventh connector C71. The seventh connector C71 may be electrically connected to a connector disposed on the seventh surface 411 of the first printed circuit board 41.

According to an embodiment, the fourth cover member 94 may press the first connector C11, the second connector C21, the fourth connector C41, the fifth connector C42, and the seventh connector C71 toward the first printed circuit board 41 so as to reduce or prevent the first connector C11 of the first flexible printed circuit board F1, the second connector C21 of the second flexible printed circuit board F2, the fourth connector C41 and the fifth connector C42 of the fourth flexible printed circuit board F4, and the seventh connector C71 of the seventh flexible printed circuit board F7 from being separated from the first printed circuit board 41.

According to an embodiment, the fourth cover member 94 may be coupled to the first support plate 1111 of the first frame 111 via a plurality of screws. When viewed from above the first cover 112, at least one screw 1200 of the plurality of screws may be positioned between the first connector C11 of the first flexible printed circuit board F1 and the antenna module 1010, or between the second connector C21 of the second flexible printed circuit board F2 and the antenna module 1010. When viewed from above the first cover 112, at least one screw 1200 may be fastened to a screw fastening portion 1201 positioned between the first printed circuit board 41 of the first support plate 1111 and the antenna module 1010.

According to an embodiment, when viewed from above the first cover 112, the second flexible printed circuit board F2 may extend between at least one screw 1200 and the antenna module 1010.

According to an embodiment, the fourth cover member 94 and the antenna module bracket 1020 may be coupled to the first support plate 1111 of the first frame 111 via at least one screw 1200. The fourth cover member 94 may include a first fastening portion 941 including a first screw hole. The antenna module bracket 1020 may include a second fastening portion 1021 including a second screw hole. The second fastening portion 1021 may be disposed between the first fastening portion 941 and the first support plate 1111 of the first frame 111.

According to an embodiment, when viewed from above the first cover 112, at least one screw 1200 may be positioned so as not to interfere with the display driver integrated circuit 72 (or a portion of the second display module 16 including the display driver integrated circuit 72). When viewed from above the second display 71, at least one screw 1200 may be spaced apart from the first lateral portion B1 of the first housing 11 with the display driver integrated circuit 72 interposed therebetween so as not to interfere with the display driver integrated circuit 72. Positioning at least one screw 1200 so as not to interfere with the display driver integrated circuit 72 (or the portion of the second display module 16 including the display driver integrated circuit 72) may be interpreted as securing an air gap between the display driver integrated circuit 72 (or the portion of the second display module 16 including the display driver integrated circuit 72) and the display driver integrated circuit overlapping portion 1300 by preventing at least one screw 1200 from being included in the display driver integrated circuit overlapping portion 1300.

According to an embodiment, an electromagnetic shielding member (also referred to as an electromagnetic shield) 1500 may be disposed on the seventh surface 411 of the first printed circuit board 41 facing the first cover 112. The electromagnetic shielding member 1500 may cover at least one electrical element (also referred to as an electronic component) 412 disposed on the seventh surface 411 of the first printed circuit board 41 and reduce electromagnetic interference with respect to the at least one electrical element 412. The electromagnetic shielding member 1500 may be electrically connected to a ground plane (also referred to as a ground area) included in the first printed circuit board 41. The electromagnetic shielding member 1500 may include a shielded can including a conductive material (or metallic material).

According to an embodiment, the electromagnetic shielding member 1500 may include a cut-out 1501 so as to avoid structural interference with the display driver integrated circuit 72 (or the portion of the second display module 16 including the display driver integrated circuit 72). The cut-out 1501 of the electromagnetic shielding member 1500 may be interpreted as securing an air gap between the display driver integrated circuit 72 (or the portion of the second display module 16 including the display driver integrated circuit 72) and the display driver integrated circuit overlapping portion 1300 by preventing the electromagnetic shielding member 1500 from being included in the display driver integrated circuit overlapping portion 1300.

According to an exemplary embodiment of the disclosure, a foldable electronic device 1 includes a first housing 11, a second housing 12, a hinge portion 14, a first display 150, a second display 71, a display driver integrated circuit 72, a printed circuit board (e.g., a first printed circuit board 41), and a battery (e.g., a first battery 51). The hinge portion 14 connects the first housing 11 and the second housing 12. The first display 150 is disposed on, at, or over the first housing 11 and the second housing 12 and is disposed across the hinge portion 14. The second display 71 is located on an opposite side of the first display 150 and is disposed in the first housing 11. The display driver integrated circuit 72 is disposed on a rear surface of the second display 71. The printed circuit board is accommodated in the first housing 11. The battery is accommodated in the first housing 11. The first housing 11 includes a first lateral portion B1, a second lateral portion B2, and a third lateral portion B3. The first lateral portion B1 and the second lateral portion B2 may extend in a first direction 5001 perpendicular to a folding axis (e.g., a center line A) of the foldable electronic device 1 and be spaced apart from each other in a second direction 5002 of the folding axis. The third lateral portion B3 is spaced apart from the folding axis in the first direction 5001 and extends in the second direction 5002. When viewed from above the second display 71, the printed circuit board is positioned between the battery and the third lateral portion B3 of the first housing 11. The battery includes a first part 511 including battery cells and a second part 512 including a battery protection circuit 5120. When viewed from above the second display 71, the second part 512 of the battery is positioned between the first part 511 of the battery and the first lateral portion B1 of the first housing 11. The second part 512 of the battery is positioned farther away from the second display 71 than the first part 511 of the battery. When viewed from above the second display, the display driver integrated circuit 72 extends in the first direction 5001 and overlaps the second part 512 of the battery.

According to an exemplary embodiment of the disclosure, when viewed from above the second display 71, the display driver integrated circuit 72 may include a third part 721 overlapped with a second part 512 of a battery (e.g., a first battery 51) and a fourth part 722 overlapped with a printed circuit board (e.g., a first printed circuit board 41).

According to an exemplary embodiment of the disclosure, a separation distance between the third part 721 of the display driver integrated circuit 72 and the second part 512 of the battery (e.g., a first battery 51) may be greater than that between the fourth part 722 of the display driver integrated circuit 72 and the printed circuit board (e.g., a first printed circuit board 41).

According to an exemplary embodiment of the disclosure, the foldable electronic device 1 may further include a first flexible printed circuit board F1 electrically connecting a battery protection circuit 5120 and a printed circuit board (e.g., a first printed circuit board 41). The first flexible printed circuit board F1 may overlap the display driver integrated circuit 72 when viewed from above the second display 71.

According to an exemplary embodiment of the disclosure, the foldable electronic device 1 may further include at least one elastic member (e.g., a first elastic member 1110 and a second elastic member 1120). The at least one elastic member may be positioned at least partially between the display driver integrated circuit 72 and the first flexible printed circuit board F1, and be disposed on the first flexible printed circuit board F1.

According to an exemplary embodiment of the disclosure, the foldable electronic device 1 may further include an antenna module 1010 and a second flexible printed circuit board F2. When viewed from above the second display 71, the antenna module 1010 may be positioned at least partially between the second part 512 of the battery (e.g., a first battery 51) and the first lateral portion B1 of the first housing 11. The antenna module 1010 may be configured to transmit or receive a signal in a millimeter-wave frequency band through the first lateral portion B1. The second flexible printed circuit board F2 may electrically connect the antenna module 1010 and the printed circuit board (e.g., the first printed circuit board 41). When viewed from above the second display 71, the second flexible printed circuit board F2 may extend between the display driver integrated circuit 72 and the first flexible printed circuit board F1.

According to an exemplary embodiment of the disclosure, when viewed from above the second display 71, the display driver integrated circuit 72 may overlap a first overlapping area included in a printed circuit board (e.g., the first printed circuit board 41), a second overlapping area included in the second part 512 of a battery (e.g., the first battery 51), and a third overlapping area included in the second flexible printed circuit board F2. When viewed from above the second display 71, the third overlapping area may be positioned between the first overlapping area and the second overlapping area in the first direction 5001.

According to an exemplary embodiment of the disclosure, the foldable electronic device 1 may further include at least one elastic member (e.g., a first elastic member 1110 and a second elastic member 1120). The at least one elastic member may be positioned at least partially between the display driver integrated circuit 72 and the second flexible printed circuit board F2, and be disposed on the second flexible printed circuit board F2.

According to an exemplary embodiment of the disclosure, when viewed from above the second display 71, the second flexible printed circuit board F2 may include a first area F21 overlapped with the printed circuit board (e.g., the first printed circuit board 41) and a second area F22 overlapped with the second part 512 of the battery (e.g., the first battery 51). A separation distance between the display driver integrated circuit 72 and the second area F22 may be greater than that between the display driver integrated circuit 72 and the first area F21. At least one elastic member may include a first elastic member 1110 disposed in the first area F21 and a second elastic member 1120 disposed in the second area F22.

According to an exemplary embodiment of the disclosure, a separation distance between the display driver integrated circuit 72 and the first elastic member 1110 may be 0.3 mm to 0.4 mm.

According to an exemplary embodiment of the disclosure, the foldable electronic device 1 may further include a cover member 94 coupled to the first housing 11 via at least one screw 1200 so as to cover a printed circuit board (e.g., the first printed circuit board 41). The cover member 94 may press a first connector C11 of a first flexible printed circuit board F1 electrically connected to the printed circuit board and a second connector C21 of a second flexible printed circuit board F2 electrically connected to the printed circuit board 41 toward the printed circuit board 41. The at least one screw 1200 may be spaced apart from the first lateral portion B1 of the first housing 11 with the display driver integrated circuit 72 interposed therebetween when viewed from above the second display 71 so as not to interfere with the display driver integrated circuit 72. When viewed from above the second display 71, at least one screw 1200 may be positioned between the first connector C11 and the antenna module 1010, or between the second connector C21 and the antenna module 1010. When viewed from above the second display 71, the second flexible printed circuit board F2 may extend between the at least one screw 1200 and the antenna module 1010.

According to an exemplary embodiment of the disclosure, the foldable electronic device 1 may further include an antenna module bracket 1020 that connects the antenna module 1010 to the first housing 11. The cover member 94 and the antenna module bracket 1020 may be coupled to the first housing 11 via at least one screw 1200.

According to an exemplary embodiment of the disclosure, the foldable electronic device 1 may further include an electromagnetic shielding member 1500 disposed on the printed circuit board (e.g., the first printed circuit board 41). The electromagnetic shielding member 1500 may have a cut-out 1501 so as not to interfere with the display driver integrated circuit 72.

According to an exemplary embodiment of the disclosure, the foldable electronic device 1 may further include at least one camera module 201 or 202 disposed in the first housing 11. When viewed from above the second display 71, the at least one camera module 201 or 202 may be positioned between the printed circuit board (e.g., the first printed circuit board 41) and the third lateral portion B3, and be positioned closer to the second lateral portion B2 than the first lateral portion B1. When viewed from above the second display 71, the second display 71 may include a first edge 7101 corresponding to the first lateral portion B1, a second edge 7102 corresponding to the second lateral portion B2, and a third edge 7103 corresponding to the third lateral portion B3. The third edge 7103 may include a first partial edge 71031 positioned apart from the third lateral portion B3 of the first housing 11 with at least one camera module 201 or 202 interposed therebetween, and a second partial edge 71032 positioned closer to the third lateral portion B3 than the first partial edge 71031. The first edge 7101 may extend in the first direction 5001 from the second partial edge 71032. The second edge 7102 may extend in the first direction 5001 from the first partial edge 71031. The display driver integrated circuit 72 may be positioned closer to the first edge 7101 than the second edge 7102.

According to an exemplary embodiment of the disclosure, the foldable electronic device 1 may further include an extension portion 73. The extension portion 73 may include a first partial extension portion 731 disposed on the rear surface of the second display 71, and a second partial extension portion bent and extended from the second display 71 toward the first partial extension portion 731 at a side of the first lateral portion B1. The display driver integrated circuit 72 may be disposed in the first partial extension portion 731.

The embodiments disclosed in the disclosure and the drawings are merely specific examples provided to more easily describe the technical content and to help the understanding of the disclosure, and are not intended to limit the scope of the disclosure. Therefore, the scope of various embodiments of the disclosure should be interpreted as including modifications or alterations in addition to the embodiments disclosed herein. Furthermore, it will be understood that any embodiment(s) described herein may be used in combination with any other embodiment(s) described herein. In particular, although the disclosure has been presented in a form that provides multiple embodiments each defining multiple features, it is emphasized that some of these embodiments are connected only by reference to the same drawing or drawings. The disclosure should be understood to include all combinations of these embodiments unless there is an explicit contradiction between two (or more) embodiments. That is, in the case where features are presented as optional in the disclosure, all combinations of such optional features are also included in the disclosure.

## Claims

1. A foldable electronic device (1), comprising:
a first housing (11), a second housing (12), and a hinge portion (14) configured to connect the first housing (11) and the second housing (12);
a first display (150) disposed in the first housing (11) and the second housing (12), and disposed across the hinge portion (14);
a second display (71) located on an opposite side of the first display (150) and disposed in the first housing (11);
a display driver integrated circuit (72) disposed on a rear surface of the second display (71);
a printed circuit board (41) accommodated in the first housing (11); and
a battery (51) accommodated in the first housing (11),
wherein the first housing (11) comprises:
a first lateral portion (B1) and a second lateral portion (B2) configured to extend in a first direction (5001) perpendicular to a folding axis (A) of the foldable electronic device (1) and spaced apart from each other in a second direction (5002) of the folding axis (A); and
a third lateral portion (B3) spaced apart from the folding axis (A) in the first direction (5001) and configured to extend in the second direction (5002),
when viewed from above the second display (71), the printed circuit board (41) is positioned between the battery (51) and the third lateral portion (B3) of the first housing (11),
the battery (51) comprises a first part (511) including battery cells and a second part (512) including a battery protection circuit (5120),
when viewed from above the second display (71), the second part (512) of the battery (51) is positioned between the first part (511) of the battery (51) and the first lateral portion (B1) of the first housing (11),
the second part (512) of the battery (51) is positioned farther away from the second display (71) than the first part (511) of the battery (51), and
when viewed from above the second display (71), the display driver integrated circuit (72) is configured to extend in the first direction (5001) and overlap the second part (512) of the battery (51).

2. The foldable electronic device of claim 1, wherein, when viewed from above the second display (71), the display driver integrated circuit (72) comprises a third part (721) overlapped with the second part (512) of the battery (51) and a fourth part (722) overlapped with the printed circuit board (41).

3. The foldable electronic device of claim 2, wherein a separation distance between the third part (721) of the display driver integrated circuit (72) and the second part (512) of the battery (51) is greater than that between the fourth part (722) of the display driver integrated circuit (72) and the printed circuit board (41).

4. The foldable electronic device of any one of claims 1 to 3, further comprising a first flexible printed circuit board (F1) configured to electrically connect the battery protection circuit (5120) and the printed circuit board (41),
wherein, when viewed from above the second display (71), the first flexible printed circuit board (F1) is configured to overlap the display driver integrated circuit (72).

5. The foldable electronic device of claim 4, further comprising at least one elastic member (1110, 1120) positioned at least partially between the display driver integrated circuit (72) and the first flexible printed circuit board (F1), and disposed on the first flexible printed circuit board (F1).

6. The foldable electronic device of claim 4, further comprising:
an antenna module (1010) positioned, when viewed from above the second display (71), at least partially between the second part (512) of the battery (51) and the first lateral portion (B1) of the first housing (11), and configured to transmit or receive a millimeter-wave frequency band signal through the first lateral portion (B1); and
a second flexible printed circuit board (F2) configured to electrically connect the antenna module (1010) and the printed circuit board (41),
wherein, when viewed from above the second display (71), the second flexible printed circuit board (F2) is configured to extend between the display driver integrated circuit (72) and the first flexible printed circuit board (F1).

7. The foldable electronic device of claim 6, wherein, when viewed from above the second display (71), the display driver integrated circuit (72) is configured to overlap a first overlapping area included in the printed circuit board (41), a second overlapping area included in the second part (512) of the battery (51), and a third overlapping area included in the second flexible printed circuit board (F2), and
when viewed from above the second display (71), the third overlapping area is positioned between the first overlapping area and the second overlapping area in the first direction (5001).

8. The foldable electronic device of claim 6 or 7, further comprising at least one elastic member (1110, 1120) positioned at least partially between the display driver integrated circuit (72) and the second flexible printed circuit board (F2), and disposed on the second flexible printed circuit board (F2).

9. The foldable electronic device of claim 8, wherein, when viewed from above the second display (71), the second flexible printed circuit board (F2) comprises a first area (F21) overlapped with the printed circuit board (41) and a second area (F22) overlapped with the second part (512) of the battery (51),
a separation distance between the display driver integrated circuit (72) and the second area (F22) is greater than that between the display driver integrated circuit (72) and the first area (F21), and
the at least one elastic member (1110, 1120) comprises a first elastic member (1110) disposed in the first area (F21) and a second elastic member (1120) disposed in the second area (F22).

10. The foldable electronic device of claim 9, wherein a separation distance between the display driver integrated circuit (72) and the first elastic member (1110) is 0.3 mm to 0.4 mm.

11. The foldable electronic device of any one of claims 6 to 10, further comprising a cover member (94) coupled to the first housing (11) via at least one screw (1200) so as to cover the printed circuit board (41),
wherein the cover member (94) is configured to press a first connector (C11) of the first flexible printed circuit board (F1) electrically connected to the printed circuit board (41) and a second connector (C21) of the second flexible printed circuit board (F2) electrically connected to the printed circuit board (41) toward the printed circuit board (41),
the at least one screw (1200) is spaced apart from the first lateral portion (B1) of the first housing (11) with the display driver integrated circuit (72) interposed therebetween when viewed from above the second display (71) so as not to interfere with the display driver integrated circuit (72),
when viewed from above the second display (71), at least one screw (1200) is positioned between the first connector (C11) and the antenna module (1010), or between the second connector (C21) and the antenna module (1010), and
when viewed from above the second display (71), the second flexible printed circuit board (F2) is configured to extend between the at least one screw (1200) and the antenna module (1010).

12. The foldable electronic device of claim 11, further comprising an antenna module bracket (1020) configured to connect the antenna module (1010) to the first housing (11),
wherein the cover member (94) and the antenna module bracket (1020) are coupled to the first housing (11) via the at least one screw (1200).

13. The foldable electronic device of any one of claims 1 to 12, further comprising an electromagnetic shielding member (1500) disposed on the printed circuit board (41),
wherein the electromagnetic shielding member (1500) has a cut-out (1501) so as not to interfere with the display driver integrated circuit (72).

14. The foldable electronic device of any one of claims 1 to 13, further comprising at least one camera module (201, 202) disposed in the first housing (11),
wherein, when viewed from above the second display (71), the at least one camera module (201, 202) is positioned between the printed circuit board (41) and the third lateral portion (B3), and is positioned closer to the second lateral portion (B2) than the first lateral portion (B1),
when viewed from above the second display (71), the second display (71) comprises a first edge (7101) corresponding to the first lateral portion (B1), a second edge (7102) corresponding to the second lateral portion (B2), and a third edge (7103) corresponding to the third lateral portion (B3),
the third edge (7103) comprises a first partial edge (71031) positioned apart from the third lateral portion (B3) of the first housing (11) with the at least one camera module (201, 202) interposed therebetween, and a second partial edge (71032) positioned closer to the third lateral portion (B3) than the first partial edge (71031),
the first edge (7101) is configured to extend from the second partial edge (71032) in the first direction (5001),
the second edge (7102) is configured to extend from the first partial edge (71031) in the first direction (5001), and
the display driver integrated circuit (72) is positioned closer to the first edge (7101) than the second edge (7102).

15. The foldable electronic device of any one of claims 1 to 14, further comprising an extension portion (73) including a first partial extension portion (731) disposed on a rear surface of the second display (71), and a second partial extension portion (732) bent and extended from the second display (71) toward the first partial extension portion (731) at a side of the first lateral portion (B1),
wherein the display driver integrated circuit (72) is disposed on the first partial extension portion (731).
